# EUROPEAN PATENT SPECIFICATION

(11) **EP 3 955 309 B1**
(45) Date of publication and mention of the grant of the patent: **08.07.2026**
(21) Application number: 21191123.5
(22) Date of filing: 12.08.2021
(51) Int. Cl.: C23C 14/04, H10K 59/121, H10K 59/35, H10K 71/16

(54) **METAL MASK AND DISPLAY APPARATUS MANUFACTURED BY USING THE SAME**
METALLMASKE UND DAMIT HERGESTELLTE ANZEIGEVORRICHTUNG
MASQUE MÉTALLIQUE ET APPAREIL D'AFFICHAGE FABRIQUÉ À L'AIDE DE CELUI-CI

(30) Priority: 14.08.2020 KR 20200102598
(43) Date of publication of application: 16.02.2022
(73) Proprietor: Samsung Display Co., Ltd., Gyeonggi-Do (KR)
(72) Inventor: PARK, Sangha, Seoul (KR); JEONG, Da-Hee, Seoul (KR); HWANG, Kyu Hwan, Seongnam-si (KR); SONG, Seungyong, Suwon-si (KR); JO, Eunbee, Hwaseong-si (KR)
(74) Representative: Marks & Clerk LLP

(56) References cited:
- CN-A- 110 098 238
- CN-A- 110 379 836
- CN-A- 110 767 708
- KR-A- 20190 071 657

## Description

### BACKGROUND

### 1. Field

Embodiments of the invention herein relate to a metal mask and a display apparatus manufactured by the same, and more particularly, to a metal mask for deposition and a display apparatus manufactured by the same.

### 2. Description of the Related Art

In general, a light emitting device is disposed in each of the pixels of a light emitting display apparatus. The light emitting device includes a light emitting layer disposed between two electrodes. The light emitting layers disposed in the pixels may be divided into a plurality of groups.

Here, a mask assembly is used to deposit the plurality of groups of light emitting layers onto a working substrate. The mask assembly includes a frame, a support stick, and a mask. Patterned light emitting layers may be provided by disposing the working substrate on the mask and then depositing a light emitting material onto the working substrate.

CN 110098238 A relates to a display panel, which has a transparent display area and a conventional display area surrounding the transparent display area.

KR20190071657A, CN110379836A and CN110767708A disclose subpixels arrangements and masks used to form subpixels of a display apparatus.

### SUMMARY

Embodiments of the invention provide a metal mask defining two kinds of openings and having improved durability.

Embodiments of the invention also provide a display apparatus including a plurality of areas including light emitting patterns having different planar areas.

An embodiment of the invention provides a metal mask as recited in claim 1

In an embodiment, the sub-opening may have a planar area greater than a planar area of the main opening.

In an embodiment, a gap between the sub-openings, which are adjacent to each other in the first direction, of the plurality of sub-openings may be greater than the gap between the main openings.

In an embodiment, a gap between a main opening of the plurality of main openings and a sub-opening of the plurality of sub-openings, the main opening and the sub-opening being adjacent to each other in a second direction tilted from the first direction, of the main openings and the sub-openings may be equal to or greater than about 0.5 times and equal to or less than about 5.0 times of a gap between the main openings, which are adjacent to each other in the second direction, of the plurality of main openings.

In an embodiment, the second area may be provided in plural, and second areas may be spaced apart from each other in the first direction with the first area therebetween.

In an embodiment, the second area may be surrounded by the first area.

In an embodiment, the second area may be provided in plural, and second areas may be adjacent to corners of the first area, respectively.

In an embodiment of the invention, a display apparatus is as recited in claim 6.

In an embodiment, the display apparatus may further include a driving circuit disposed on the second area, and at least a portion of the plurality of sub-light emitting devices may overlap the driving circuit in a plan view.

In an embodiment, the display apparatus may further include an electronic module disposed in overlap with the second area, and the second area may have a transmittance less than a transmittance of the first area.

In an embodiment, the second planar area may be greater than the first planar area.

In an embodiment, the main light emitting pattern and the sub-light emitting pattern, which are adjacent to each other, may be arranged along a reference axis extending in the first direction.

In an embodiment, the plurality of light emitting devices may emit light having a green color.

In an embodiment, a gap between the main light emitting pattern and the sub-light emitting pattern, which are adjacent to each other in a second direction tilted from the first direction, may be equal to or greater than about 0.5 times and equal to or less than about 5.0 times of a gap between the main light emitting patterns, which are adjacent to each other in the second direction, of the plurality of the main light emitting patterns.

In an embodiment, the plurality of light emitting devices may emit red or blue light.

In an embodiment, the second area may be provided in plural, and second areas may be adjacent to corners of the first area, respectively.

In an embodiment, the display apparatus may further include additional main light emitting patterns disposed on the first area to emit light having a color different from a color of the main light emitting patterns, and at least a portion of the additional main light emitting patterns and the main light emitting patterns may overlap each other in a plan view.

In an embodiment, the display apparatus may further include additional sub-light emitting patterns disposed on the second area to emit light having a same color as a color of the additional main light emitting patterns, and the additional sub-light emitting patterns and the sub-light emitting patterns may be spaced apart from each other in a plan view.

At least some of the above and other features of the invention are set out in the claims.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain principles of the invention. In the drawings:
FIG. 1A is a block diagram representing an embodiment of a display apparatus according to the invention;
FIG. 1B is a plan view of an embodiment of a display panel according to the invention;
FIG. 2 is a plan view illustrating an embodiment of a partial area of the display panel according to the invention;
FIG. 3 is a cross-sectional view illustrating an embodiment of a partial area of the display panel according to the invention;
FIG. 4 is a cross-sectional view of a deposition apparatus;
FIG. 5 is a perspective view of a mask assembly;
FIG. 6A is a plan view of an embodiment of a working substrate according to the invention;
FIG. 6B is a plan view of one unit cell area in FIG. 6A;
FIG. 7 is an enlarged plan view illustrating area AA in FIG. 6B;
FIG. 8A is an enlarged plan view illustrating an embodiment of a mask according to the invention;
FIG. 8B is a cross-sectional view illustrating an arrangement relationship between a working substrate and the mask in FIG. 8A;
FIGS. 8C and 8D are enlarged plan views of embodiments of masks according to the invention;
FIG. 9 is an enlarged plan view illustrating a partial area of a working substrate in FIG. 6B;
FIGS. 10A to 10C are enlarged plan views illustrating an embodiment of a portion of masks according to the invention;
FIG. 11A is a plan view illustrating an embodiment of a partial area of a working substrate according to the invention;
FIGS. 11B to 11D are plan views illustrating embodiments of portions of masks according to the invention;
FIG. 12A is a perspective view illustrating an embodiment of a portion of a display apparatus according to the invention;
FIG. 12B is a plan view of a unit cell for constituting a display panel in FIG. 12A;
FIG. 13A is a perspective view of an embodiment of a display apparatus according to the invention; and
FIG. 13B is a plan view illustrating one unit cell area of the display apparatus in FIG. 13A.

### DETAILED DESCRIPTION

It will be understood that when an element such as a region, layer, or portion is referred to as being "on" another element, it can be directly on the other element or intervening elements may also be present.

Like reference numerals refer to like elements throughout. Also, in the drawing figures, the thickness, ratio, and dimensions of components are exaggerated for clarity of illustration. As used herein, the term and/or includes any and all combinations of one or more of the associated listed items.

It will be understood that although the terms such as 'first' and 'second' are used herein to describe various elements, these elements should not be limited by these terms. The terms are only used to distinguish one component from other components. For example, a first element referred to as a first element in one embodiment can be referred to as a second element in another embodiment without departing from the scope of the appended claims. The terms of a singular form may include plural forms unless referred to the contrary.

Also, spatially relative terms, such as "below", "lower", "above", and "upper", may be used herein for ease of description to describe an element and/or a feature's relationship to another element(s) and/or feature(s) as illustrated in the drawings. The terms may be a relative concept and described based on directions expressed in the drawings.

The meaning of 'include' or 'comprise' specifies a property, a region, a fixed number, a step, a process, an element and/or a component but does not exclude other properties, regions, fixed numbers, steps, processes, elements and/or components.

The terminology used herein is for the purpose of describing particular embodiments only and is not intended to be limiting. As used herein, the singular forms "a," "an," and "the" are intended to include the plural forms, including "at least one," unless the content clearly indicates otherwise. "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. In an embodiment, when the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, when the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

Unless otherwise defined, all terms (including technical and scientific terms) used herein have the same meaning as generally understood by those skilled in the art. Terms as defined in a commonly used dictionary should be construed as having the same meaning as in an associated technical context, and unless defined apparently in the description, the terms are not ideally or excessively construed as having formal meaning.

Hereinafter, embodiments of the invention will be described with reference to the accompanying drawings.

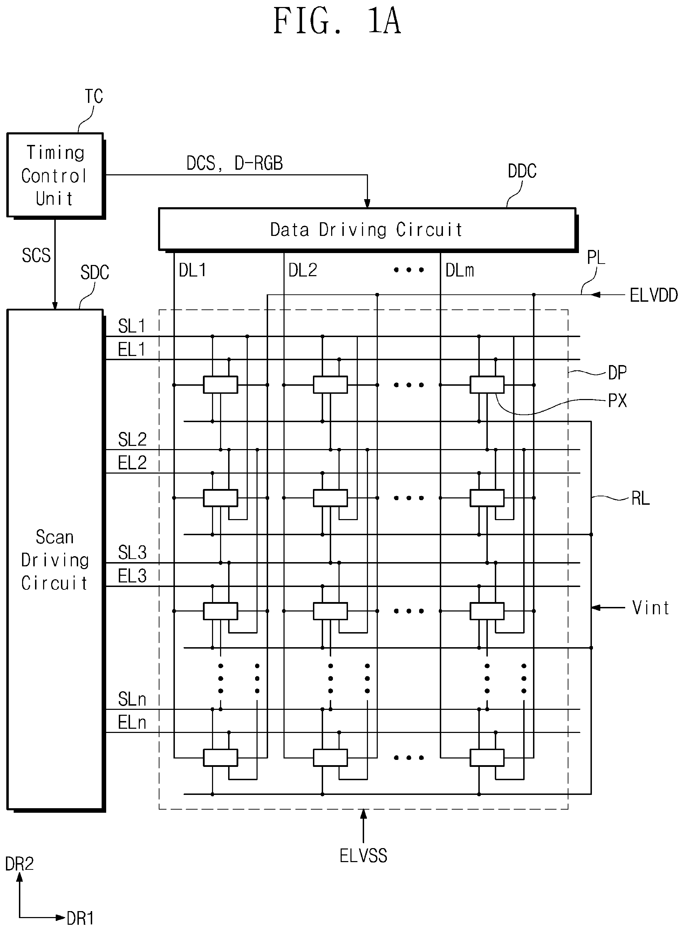

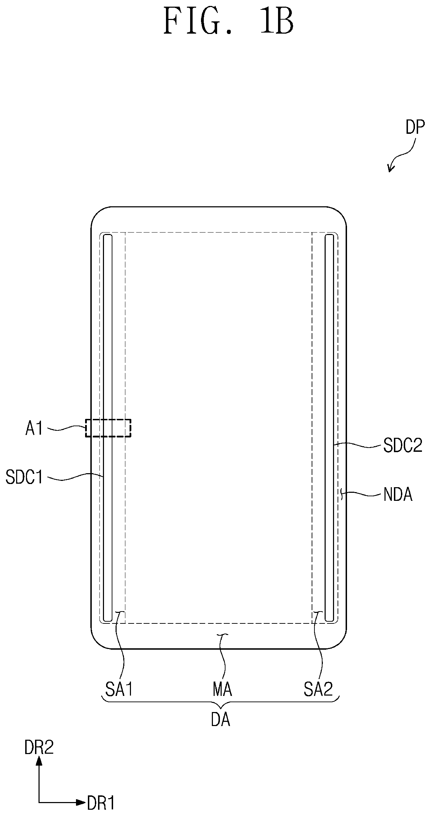

FIG. 1A is a block diagram of an embodiment of a display apparatus according to the invention. FIG. 1B is a plan view of an embodiment of a display panel according to the invention. Hereinafter, an embodiment of the invention will be described with reference to FIGS. 1A to 1B.

FIG. 1A is a block diagram of an embodiment of an electronic apparatus according to the invention. The display apparatus in an embodiment of the invention may be a semiconductor apparatus including at least one semiconductor. The electronic apparatus includes a timing control unit TC, a scan driving circuit SDC, a data driving circuit DDC, and a display panel DP. The display panel DP displays an image according to an electric signal.

In the embodiment, the display panel DP is described as an organic light emitting display panel. However, this is merely illustrative. The display panel DP of the invention may include various embodiments, for example.

The timing control unit TC receives input image signals (not shown) and converts a data format of the input image signals to be matched with specifications of an interface with the scan driving circuit SDC, thereby generating the image data D-RGB. The timing control unit TC outputs the image data D-RGB and all sorts of control signals DCS and SCS.

The scan driving circuit SDC receives a scan control signal SCS from the timing control unit TC. The scan control signal SCS may include a vertical start signal that starts an operation of the scan driving circuit SDC and a clock signal that determines an output time of signals.

The scan driving circuit SDC generates a plurality of scan signals and sequentially outputs the scan signals to a plurality of scan lines SL1 to SLn where n is a natural number. Also, the scan driving circuit SDC generates a plurality of light emitting control signals in response to the scan control signal SCS and outputs the light emitting control signals to a plurality of light emitting lines EL1 to ELn.

Although the scan signals and the light emitting control signals are outputted from one scan driving circuit SDC in FIG. 1A, the invention is not limited thereto. In an embodiment of the invention, the scan driving circuits may divide and output scan signals and divide and output light emitting control signals. Also, in an embodiment of the invention, a driving circuit generating and outputting scan signals and a driving circuit generating and outputting light emitting control signals may be separately distinguished.

The data driving circuit DDC receives a data control signal DCS and image data D-RGB from the timing control unit TC. The data driving circuit DDC converts the image data D-RGB into data signals and outputs the data signals to the data lines DL1 to DLm where m is a natural number. The data signals are analog voltages corresponding to gray values of the image data D-RGB.

The display panel DP includes scan lines SL1 to SLn, light emitting lines EL1 to ELn, data lines DL1 to DLm, and pixels PX. The scan lines SL1 to SLn may each extend in the first direction DR1 and be arranged in a second direction DR2 crossing the first direction DR1.

Each of the plurality of light emitting lines EL1 to ELn may be arranged in parallel to the corresponding scan line of the scan lines SL1 to SLn. The data lines DL1 to DLm cross the scan lines SL1 to SLn in an insulating manner.

Each of the pixels PX is connected to the corresponding scan line of the scan lines SL1 to SLn, the corresponding light emitting line of the light emitting lines EL1 to ELn, and the corresponding data line of the data lines DL1 to DLm.

Each of the pixels PX receives a power voltage ELVSS (hereinafter, also referred to as a first voltage) a second voltage ELVDD having a level greater than that of the power voltage ELVSS. Each of the pixels PX is connected to a power line PL to which the second voltage ELVDD is applied. Each of the pixels PX is connected to an initialization line RL receiving an initialization voltage Vint.

Each of the pixels PX may be electrically connected to three scan lines. As illustrated in FIG. 1, the pixels in a second pixel row may be connected to the first to third scan lines SL1 to SL3.

Also, the display panel DP may further include a plurality of dummy scan lines. The display panel DP may further include a dummy scan line connected to the pixels PX in a first pixel row and a dummy scan line connected to the pixels PX in an n-th pixel row. Also, the pixels (hereinafter, also referred to as pixels in a pixel row) connected to one data line of the data lines DL1 to DLm may be connected to each other. Two neighboring pixels of the pixels in the pixel row may be electrically connected to each other. However, this is merely illustrative, and the invention is not limited thereto. In another embodiment, the connection relationship between the pixels PX in an embodiment of the invention may be variously designed, for example.

Each of the pixels PX includes an organic light emitting diode (not shown) and a pixel driving circuit (not shown) controlling light emission of the organic light emitting diode. The pixel driving circuit may include a thin-film transistor ("TFT") and a capacitor.

In this embodiment, at least one of the scan driving circuit SDC and the data driving circuit DDC may include TFTs provided through the same process as that of the pixel driving circuit. In an embodiment, all of the scan driving circuit SDC and the data driving circuit DDC may be disposed (e.g., mounted) on the display panel DP, for example. In an alternative embodiment, one of the scan driving circuit SDC and the data driving circuit DDC may be disposed (e.g., mounted) to the display panel DP, and the other may be provided as a separate circuit board that is independent from the display panel DP and then connected to the display panel DP.

Referring to FIG. 1B, the scan driving circuit SDC may be disposed on the display panel DP. In this embodiment, the scan driving circuit SDC may include a first scan driving circuit SDC1 and a second scan driving circuit SDC2, which are spaced apart from each other in the first direction DR1. The first scan driving circuit SDC1 and the second scan driving circuit SDC2 may be provided in the same process as that of the above-described pixels PX.

Each of the first scan driving circuit SDC1 and the second scan driving circuit SDC2 may generate a plurality of scan signals and a plurality of light emission control signals and output the generated signals to the corresponding pixels. In an embodiment, the first scan driving circuit SDC1 may generate a plurality of scan signals, and the second scan driving circuit SDC2 may generate a plurality of light emission control signals, for example. In an alternative embodiment, the first scan driving circuit SDC1 and the second scan driving circuit SDC2 may generate the scan signal and the light emission control signal, respectively, with respect to pixel rows that are alternate to each other.

Also, the display panel DP may include a single scan driving circuit. Although the scan driving circuit in an embodiment of the invention may have various types, the invention is not limited thereto.

The display panel DP includes a display area DA and a peripheral area (also referred to as a non-display area) NDA. The peripheral area NDA may surround an edge of the display area DA. However, this is merely illustrative, and the invention is not limited thereto. In an embodiment of the display panel according to the invention, the peripheral area NDA may be defined at one side of the edge of the display area DA or omitted, for example.

The display area DA may include a main area MA, a first sub-area SA1, and a second sub-area SA2. The first sub-area SA1 and the second sub-area SA2 are spaced apart from each other with the main area MA therebetween in the first direction DR1.

The main area MA may be spaced apart from each of the first scan driving circuit SDC1 and the second scan driving circuit SDC2. The main area MA may be an area on which a portion of the pixels PX is disposed.

The first sub-area SA1 overlaps the first scan driving circuit SDC1. The first sub-area SA1 may be an area on which another portion of the pixels PX is disposed. At least a portion of the pixels PX disposed on the first sub-area SA1 overlaps the first scan driving circuit SDC1. An image displayed on the first sub-area SA1 may be the same as or related to that displayed on the main area MA or an independent separate image. However, the invention is not limited thereto.

The second sub-area SA2 overlaps the second scan driving circuit SDC2. The second sub-area SA2 may be an area on which a portion of the pixels PX is disposed. At least a portion of the pixels PX disposed on the second sub-area SA2 overlaps the second scan driving circuit SDC2. An image displayed on the second sub-area SA2 may be the same as or related to that displayed on the main area MA or an independent separate image. However, the invention is not limited thereto.

According to the embodiment, at least a portion of the pixels PX may be disposed on the first and second sub-areas SA1 and SA2 and overlap the first and second scan driving circuits SDC1 and SDC2 in a plan view. Thus, a planar area of the display area DA provided by the display panel DP may be expanded to an area overlapping the first and second scan driving circuits SDC1 and SDC2, and a planar area of the peripheral area NDA may be reduced. Thus, the display panel DP may easily realize the display apparatus having a reduced bezel area.

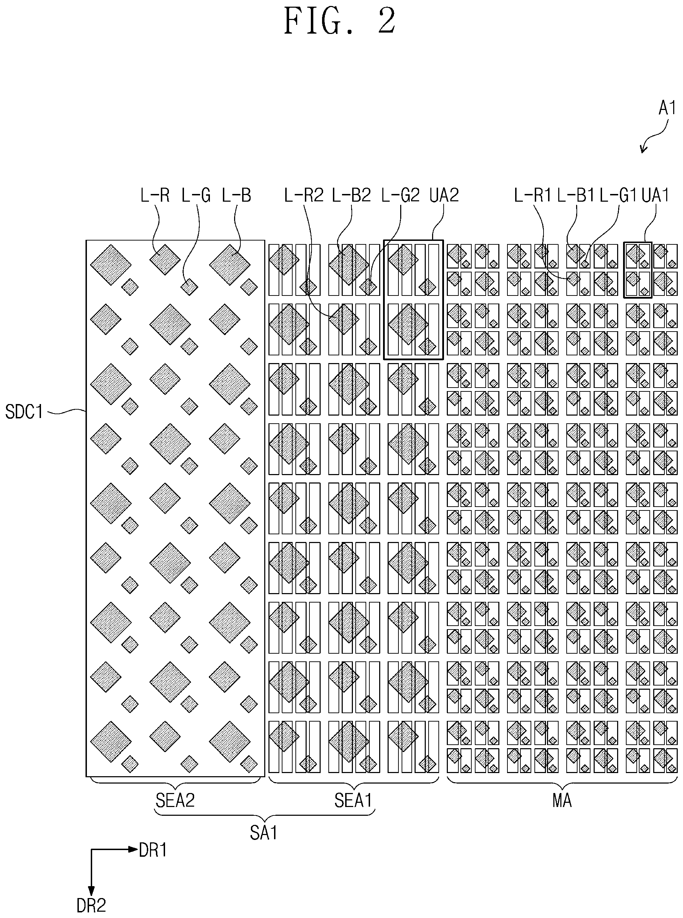

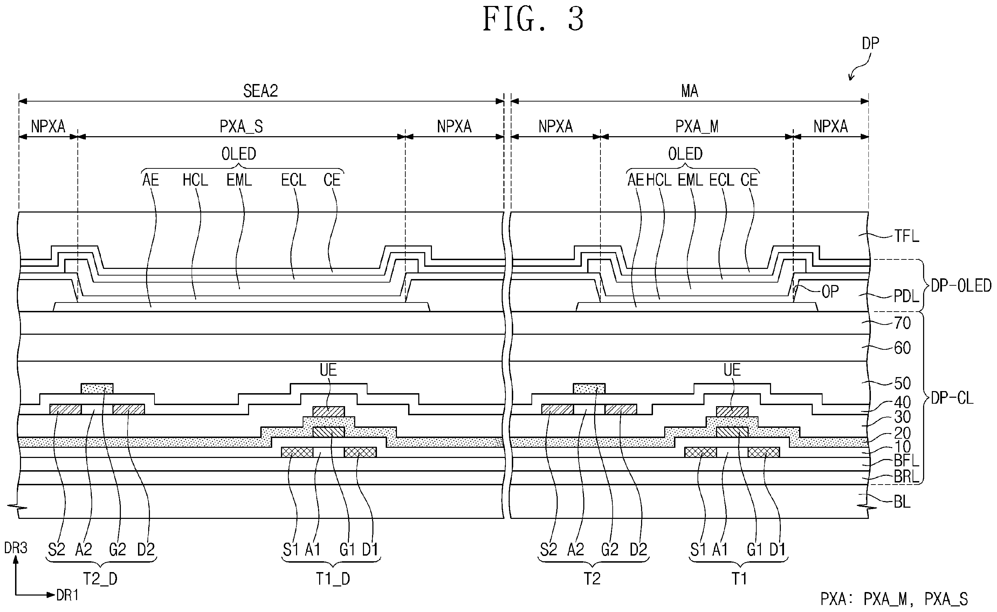

FIG. 2 is a plan view illustrating an embodiment of a partial area of the display panel according to the invention. FIG. 3 is a cross-sectional view illustrating an embodiment of a partial area of the display panel according to the invention. In FIG. 2, area A1 of FIG. 1B is simply illustrated, and in FIG. 3, one pixel area PXA_M disposed on the main area MA and one pixel area PXA_S disposed on the first sub-area SA1 (hereinafter, also referred to as a sub-area) are simply illustrated. Hereinafter, an embodiment of the invention will be described with reference to FIGS. 2 to 3.

As illustrated in FIG. 2, the main area MA may include a plurality of first unit areas UA1. The first unit areas UA1 include first to third light emitting areas L-R1, L-G1, and L-B1 having the same arrangement of the light emitting areas. That is, arrangements of the first to third light emitting areas L-R1, L-G1, and L-B1 in each of the first unit areas UA1 may be the same as each other.

In this embodiment, each of the first unit areas UA1 may include one first light emitting area L-R1, two second light emitting areas L-G1, and one third light emitting area L-B1. Here, one of the two second light emitting areas L-G1 may be defined as a fourth light emitting area that is distinguished from the second light emitting area L-G1. In an embodiment, the fourth light emitting area may have a planar shape different from that of the second light emitting area L-G1, for example. In an alternative embodiment, the fourth light emitting area may have a color different from that of the second light emitting area L-G1. However, this is merely illustrative, and the embodiment of the invention is not limited to the number or kind of the light emitting areas constituting each of the first unit areas UA1.

The sub-area SA1 may include a plurality of second unit areas UA2. The second unit areas UA1 include first to third light emitting areas L-R2, L-G2, and L-B2 having the same arrangement of the light emitting areas. That is, arrangements of the first to third light emitting areas L-R2, L-G2, and L-B2 in each of the second unit areas UA2 may be the same as each other.

In this embodiment, each of the second unit areas UA2 may include the first to third light emitting areas L-R2, L-G2, and L-B2 having an arrangement corresponding to each of the first unit areas UA1. The arrangement relationship between the first to third light emitting areas L-R2, L-G2, and L-B2 in each of the second unit areas UA2 may correspond to that between the first to third light emitting areas L-R1, L-G1, and L-B1 in each of the first unit areas UA1.

Here, the second unit area UA2 may have a planar area greater than that of the first unit area UA1. Also, each of the first to third light emitting areas L-R2, L-G2, and L-B2 constituting the second unit areas UA2 may have a planar area greater than that of each of the first to third light emitting areas L-R1, L-G1, and L-B1 constituting the first unit areas UA1.

When light emitting areas of corresponding light emitting devices are different, and the same driving voltage is applied to the corresponding light emitting devices, a ratio of luminance of the corresponding light emitting devices is proportional to a ratio of the light emitting areas. In this embodiment, since the number of light emitting areas per unit area is less in the sub-area SA1 than the main area MA, when the same driving voltage is supplied to the same light emitting area, the sub-area SA1 may have luminance per unit area less than that of the main area MA.

In an embodiment of the invention, each of the first to third light emitting areas L-R2, L-G2, and L-B2 of the first area SEA1 of the sub-area SA1 has a planar area greater than that of each of the corresponding first to third light emitting areas L-R1, L-G1, and L-B1 of the main area MA to compensate the luminance difference between the sub-area SA1 and the main area MA. Thus, although the sub-area SA1 has the number of light emitting areas per unit area less than the main area MA, the sub-area SA1 and the main area MA may have the same luminance per unit area by designing light emitting area to have an increased area.

Also, the sub-area SA1 may be divided into a first area SEA1 and a second area SEA2. The first area SEA1 is an area spaced apart from the first scan driving circuit SDC1 in the sub-area SA1 and disposed between the second area SEA2 and the main area MA. The second area SEA2 may be an area overlapping the first scan driving circuit SDC1 in a plan view in the sub-area SA1. In an embodiment, first to third light emitting areas L-R, L-G, and L-B of the second area SEA2 of the sub-area SA1 may be identical to the first to third light emitting areas L-R2, L-G2, and L-B2 of the first area SEA1 of the sub-area SA1, respectively, but the invention is not limited thereto.

A portion of the second unit areas UA2 disposed on the second area SEA2 overlap the first scan driving circuit SDC1 in a plan view. FIG. 3 illustrates a cross-sectional view of one light emitting area PXA_S (hereinafter, also referred to as a sub-light emitting area) disposed on the second area SEA2 and one light emitting area PXA_M (hereinafter, also referred to as a main light emitting area) disposed on the main area MA for easy description.

As illustrated in FIG. 3, the display panel DP includes a base layer BL, a circuit device layer DP-CL disposed on the base layer BL, a display apparatus layer DP-OLED disposed on the circuit device layer DP-CL, and an insulation layer TFL (hereinafter, also referred to as an upper insulation layer) disposed on the display apparatus layer DP-OLED.

The base layer BL may include a synthetic resin layer. A synthetic resin layer is provided on a support substrate that is used when the display panel DP is manufactured. Thereafter, a conductive layer, an insulation layer, and the like are provided on the synthetic resin layer. When the support substrate is removed, the synthetic resin layer corresponds to the base layer BL.

The circuit device layer DP-CL includes at least one insulation layer and a circuit device. The circuit device includes a signal line, a driving circuit of the pixel, etc. The circuit device layer DP-CL may be provided through a process of providing an insulation layer, a semiconductor layer, and a conductive layer by coating or deposition and a process of patterning the insulation layer, the semiconductor layer, and the conductive layer by a photolithography process.

In this embodiment, the circuit device layer DP-CL includes a buffer layer BFL, a barrier layer BRL, and first to seventh insulation layers 10, 20, 30, 40, 50, 60, and 70. Each of the buffer layer BFL, the barrier layer BRL, and the first to seventh insulation layers 10 to 70 may include one of an inorganic layer and an organic layer. Each of the buffer layer BFL and the barrier layer BRL may include an inorganic layer. At least one of the fifth to seventh insulation layers 50, 60, and 70 may include an organic layer.

The circuit device layer DP-CL may include a first pixel transistor T1, a second pixel transistor T2, a first driving transistor T1_D, and a second driving transistor T2_D. The first and second pixel transistors T1 and T2 are disposed on the main area MA. The first and second pixel transistors T1 and T2 may constitute the pixel PX in conjunction with the light emitting device OLED disposed thereabove.

FIG. 3 illustrates an arrangement relationship of a first channel A1, a second channel A2, a first gate G1, a second gate G2, a first source S1, a second source S2, a first drain D1, and a second drain D2, which constitute the first and second pixel transistors T1 and T2. In this embodiment, the first channel A1 and the second channel A2 may include materials different from each other. The first channel A1 may include a polysilicon semiconductor, and the second channel A2 may include a metal oxide semiconductor. Each of the first source S1 and the first drain D1, which has a doping concentration greater than that of the first channel A1, has a function of an electrode. Each of the second source S2 and the second drain D2, which reduces the metal oxide semiconductor, has a function of an electrode.

In an embodiment of the invention, the first channel A1 and the second channel A2 may include the same semiconductor material as each other. Here, a laminated structure of the circuit device layer DP-CL may be further simplified. Also, the circuit device layer DP-CL may further include an upper electrode UE. The upper electrode UE may overlap the first gate G1. The upper electrode UE may provide a gate electrode of the first pixel transistor T1 in conjunction with the first gate G1 or provide a capacitor in conjunction with the first gate G1. However, this is merely illustrative. In an embodiment, the upper electrode UE may be omitted from the display panel DP according to the invention, for example.

The first and second driving transistors T1_D and T2_D are disposed on the second area SEA2 of the sub-area SA1. The first and second driving transistors T1_D and T2_D are included in the scan driving circuit SDC1. The first and second driving transistors T1_D and T2_D may have the same structure and be provided in the same process as that of the first and second pixel transistors T1 and T2. However, this is merely illustrative, and the invention is not limited thereto. In an embodiment, the scan driving circuit SDC1 may include only one kind of the first and second driving transistors T1_D and T2_D, for example.

The display apparatus layer DP-OLED includes a pixel defining layer PDL and a light emitting device OLED. The light emitting device OLED may be an organic light emitting diode or a quantum dot light emitting diode. An anode AE is disposed on the seventh insulation layer 70. An opening OP of the pixel defining layer PDL exposes at least a portion of the anode AE. The opening OP of the pixel defining layer PDL may define light emitting areas PXA_M and PXA_S. A non-light emitting area NPXA may surround the light emitting areas PXA_M and PXA_S.

A hole control layer HCL and an electron control layer ECL may be disposed on the light emitting area PXA and the non-light emitting area NPXA in common. A light emitting layer EML may have a pattern shape corresponding to the opening OP. The light emitting layer may be deposited in a different method in comparison with the film-type hole control layer HCL and the film-type electron control layer ECL. A mask assembly may be used to provide the light emitting layer EML having a predetermined shape.

The hole control layer HCL and the electron control layer ECL may be provided in the plurality of pixels in common by an open mask. The light emitting layer EML may be provided differently according to the pixels by a mask referred to as fine metal mask ("FMM"). A cathode CE is disposed on electron control layer and opposing to the anode AE.

The upper insulation layer TFL is disposed on the cathode CE. The upper insulation layer TFL may include a plurality of thin-films. The plurality of thin-films may include an inorganic layer and an organic layer. The upper insulation layer TFL may include an insulation layer for encapsulating the display apparatus layer DP-OLED and an insulation layer for improving a light emission efficiency.

As described above, the light emitting areas PXA_M and PXA_S are provided on the first and second driving transistors T1_D and T2_D as well as the first and second pixel transistors T1 and T2. The display panel DP may display an image even on the sub-area SA1 on which the scan driving circuit SDC1 is disposed by including the light emitting device OLED overlapping the first and second driving transistors T1_D and T2_D. Thus, the display panel DP, in which the display area is expanded, and the bezel is reduced, may be provided.

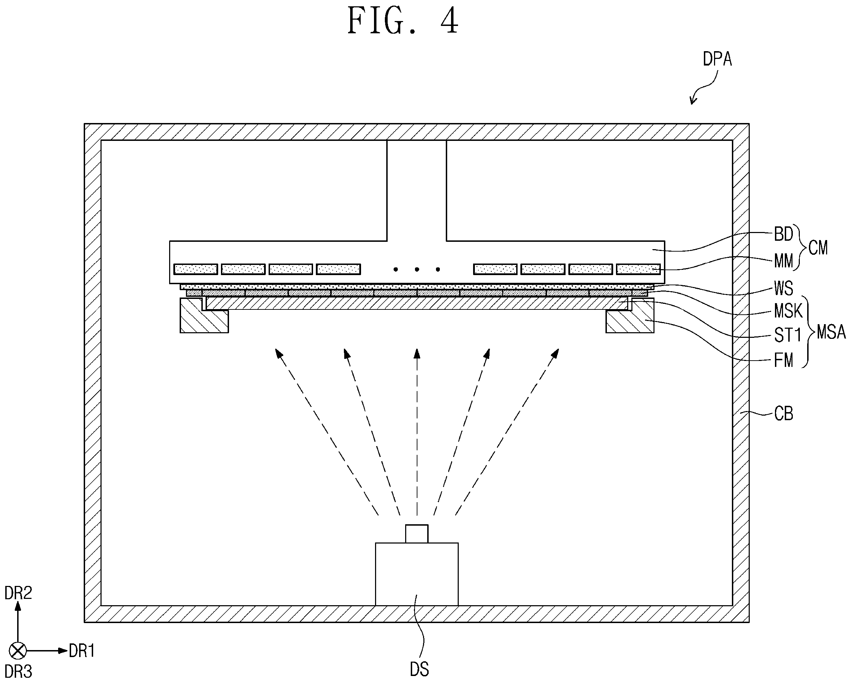

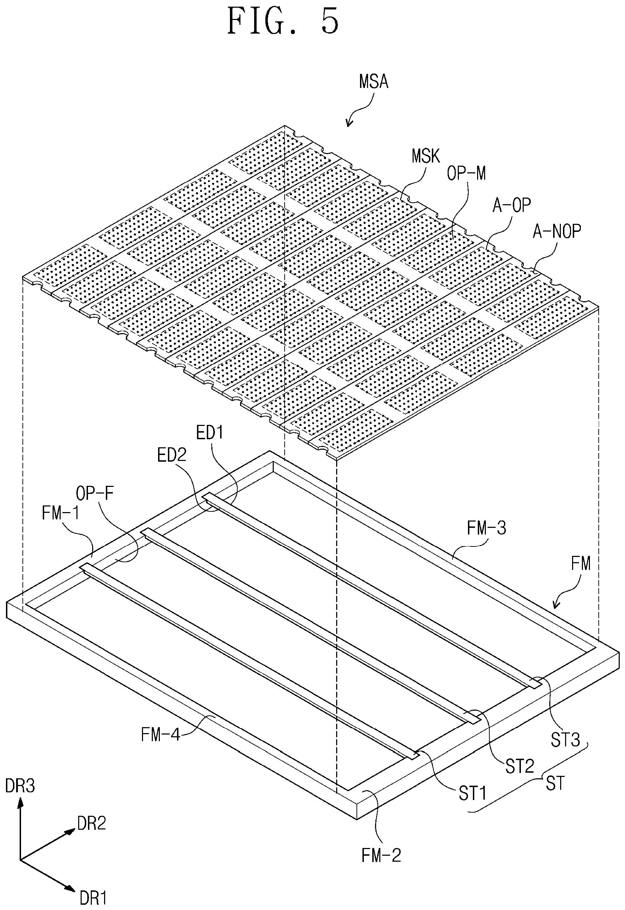

FIG. 4 is a cross-sectional view of a deposition apparatus. FIG. 5 is a perspective view of a mask assembly MSA. A deposition apparatus DPA may be used in a deposition process for the display panel DP, particularly for the light emitting layer EML in FIG. 3. The deposition apparatus DPA includes a deposition chamber CB, a fixing member CM, a deposition source DS, and a mask assembly MSA. Although not separately shown, the deposition apparatus DPA may further include an additional mechanical device for realizing an in-line system.

The deposition chamber CB may set a deposition condition as vacuum. The deposition chamber CB may include a bottom surface, a ceiling surface, and sidewalls. The bottom surface of the deposition chamber CB may be parallel to a surface defined by the first directional axis DR1 and the second directional axis DR2. A normal direction of the bottom surface of the deposition chamber CB indicates a third directional axis DR3. Hereinafter, first to third directions may be directions indicated by the first to third directional axes DR1, DR2, and DR3, respectively, and designated by the same reference numerals, respectively. Hereinafter, an expression "in a plan view" represents a surface parallel to the surface defined by the first directional axis DR1 and the second directional axis DR2.

The fixing member CM is disposed inside the deposition chamber CB and disposed above the deposition source DS to fix the mask assembly MSA. The fixing member CM may be installed on the ceiling surface of the deposition chamber CB. The fixing member CM may include a jig or a robot arm holding the mask assembly MSA.

The fixing member CM includes a body part BD and magnetic bodies MM coupled to the body part BD. The body part BD may include a plate as a base structure for fixing the mask assembly MSA. However, the invention is not limited thereto. The magnetic bodies MM may be disposed inside or outside the body part BD. The magnetic bodies MM may fix the mask assembly MSA by a magnetic force.

The deposition source DS may evaporate a deposition material, e.g., a light emitting material, to be ejected as deposition vapor. The deposition vapor passes through the mask assembly MSA and is deposited on a working substrate WS with a predetermined pattern.

The mask assembly MSA is disposed inside the deposition chamber CB and disposed above the deposition source DS to support the working substrate WS. The working substrate WS may include a glass substrate or a plastic substrate. The working substrate WS may include a polymer layer disposed on the base substrate. The base substrate may be removed in the latter half of the process for manufacturing the display panel, and the polymer layer may correspond to the base layer BL in FIG. 3.

As illustrated in FIG. 5, the mask assembly MSA includes a frame FM, a plurality of sticks ST, and a plurality of masks MSK. Although the mask assembly MSA including one kind of sticks ST extending in the same direction is illustrated in this embodiment, the mask assembly MSA in an embodiment of the invention may further include different kinds of sticks extending in different directions.

An opening OP-F is defined in the frame FM. The frame FM may have a quadrangular (e.g., rectangular) shape in a plan view. The frame FM may include a metal material. In an embodiment, the frame FM may include, e.g., nickel (Ni), a nickel-cobalt alloy, a nickel-iron alloy or a combination thereof, etc., for example. The frame FM may include four portions. The frame FM may include a first extension portion FM-1 and a second extension portion FM-2, which face each other in the first direction DR1. The FM may include a third extension portion FM-3 and a fourth extension portion FM-4, which face each other in the second direction DR2 and each of which connects the first extension portion FM-1 and the second extension portion FM-2. The first to fourth extension portions FM-1 to FM-4 may be coupled by welding or integrated with each other.

The sticks ST include first to third sticks ST1, ST2, and ST3. The first to third sticks ST1, ST2, and ST3 may be coupled to the frame FM to overlap the first opening OP-F. The first to third sticks ST1, ST2, and ST3 may be coupled to coupling grooves defined in each of the first extension portion FM-1 and the second extension portion FM-2. However, the embodiment of the invention is not limited to the number of the sticks ST. In an embodiment, the sticks ST may be integrated with the frame FM, for example. In an embodiment, each of the first to third sticks ST1, ST2, and ST3 may include first and second edges ED1 and ED2 opposite to each other.

The masks MSK may be disposed on the frame FM and the sticks ST and arranged in the first direction DR1 while extending in the second direction DR2. The masks MSK may include a material such as an invar having a thermal expansion coefficient less than that of the frame FM. In an embodiment, the masks MSK may include, e.g., nickel (Ni), a nickel-cobalt alloy, a nickel-iron alloy, or a combination thereof, etc., for example.

A plurality of openings OP-M (hereinafter, also referred to as mask openings) is defined in each of the masks MSK. Each of the masks MSK may include an opening area A-OP in which the mask openings OP-M are defined and a non-opening area A-NOP disposed adjacent to the opening area A-OP. In this embodiment, each of the masks MSK may include the single opening area A-OP that is consecutively defined along the second direction DR2. The mask openings OP-M are arranged with a predetermined rule (or uniformly) in the opening area A-OP. The light emitting layer EML may have a planar shape corresponding to that of the mask openings OP-M.

The masks MSK may be coupled to the frame FM by welding. In a process of manufacturing the mask assembly MSA, the masks MSK are welded to the frame FM in a state in which each of the masks MSK is tensioned in the second direction DR2. The mask assembly MSA includes a plurality of divided masks MSK. A deflection phenomenon may be generated less in the masks MSK than one largesized mask corresponding to the frame FM.

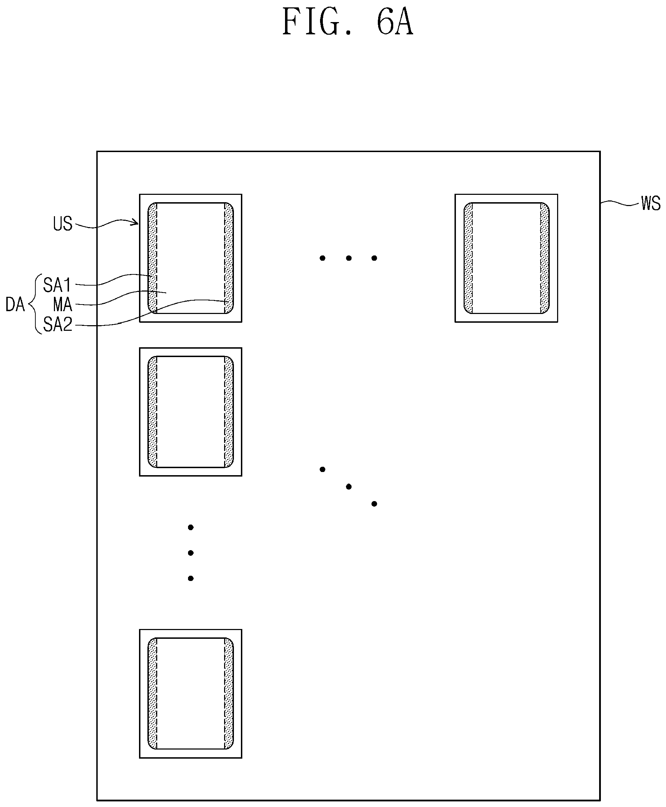

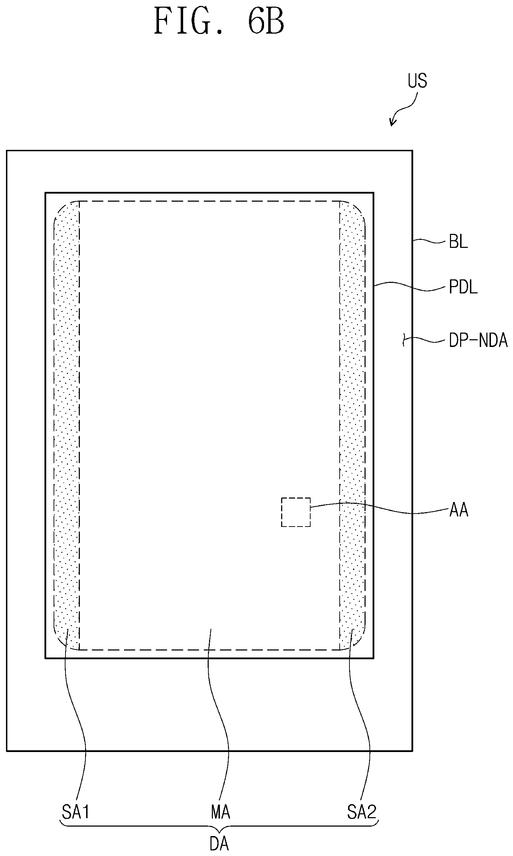

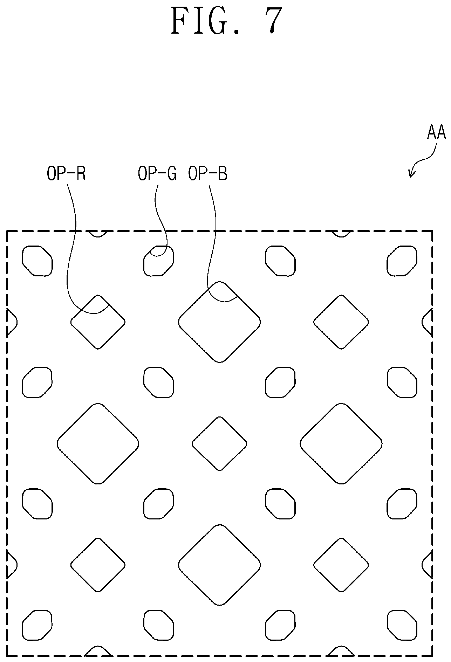

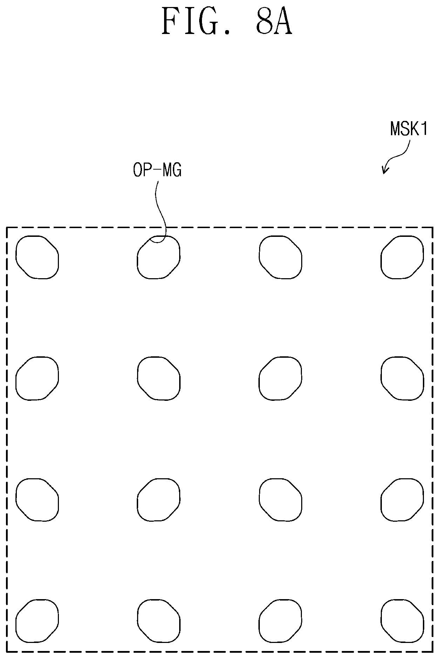

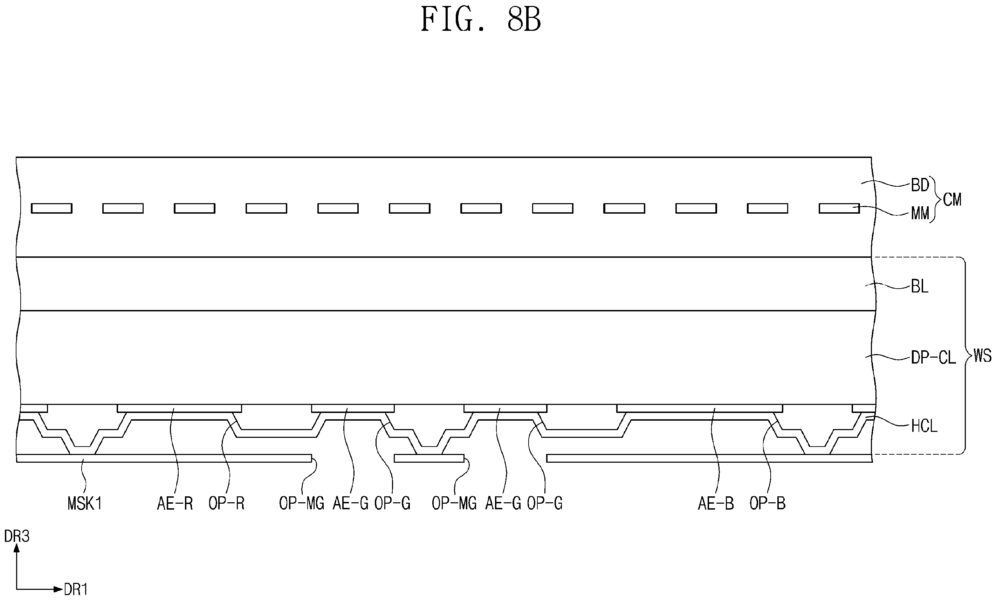

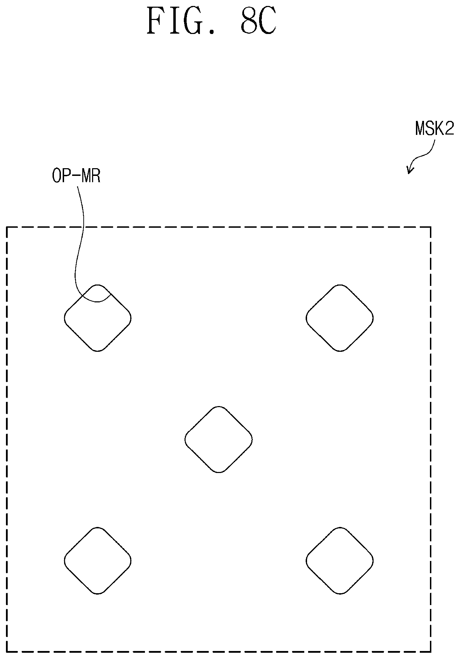

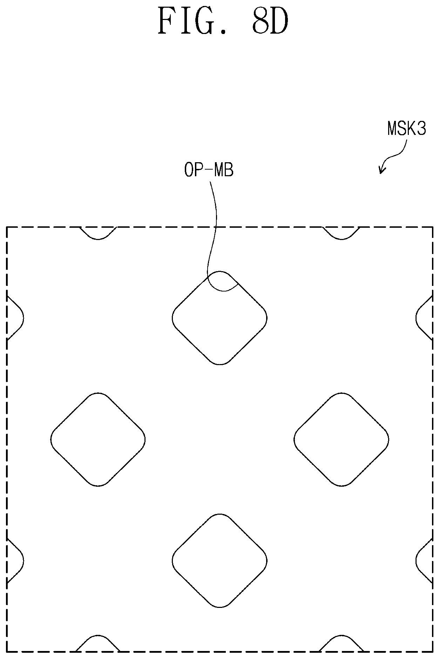

FIG. 6A is a plan view of an embodiment of the working substrate according to the invention. FIG. 6B is a plan view illustrating one unit cell area in FIG. 6A. FIG. 7 is an enlarged plan view illustrating area AA in FIG. 6B. FIG. 8A is an enlarged plan view of an embodiment of a mask according to the invention, and FIG. 8B is a cross-sectional view illustrating an arrangement relationship between the mask and the working substrate in FIG. 8A. FIGS. 8C and 8D are enlarged plan views of embodiments of masks according to the invention. Hereinafter, an embodiment of the invention will be described with reference to FIGS. 6A to 8D.

A working substrate WS in FIG. 6A includes a plurality of unit cell areas US. Each of the unit cell areas US may be separated after a process in the working substrate WS is finished to provide the display panel DP (refer to FIG. 1B). In this embodiment, the working substrate WS is in a state before a thin-film pattern is provided by the mask assembly MSA (refer to FIG. 5). In an embodiment, the working substrate WS may be in a state in which the hole control layer HCL (refer to FIG. 3) is provided, for example.

Referring to FIGS. 6A and 6B, the pixel defining layer PDL overlaps the entire display area DA. A portion of the pixel defining layer PDL may overlap the non-display area NDA. Although the pixel defining layer PDL having a quadrangular (e.g., rectangular) shape is illustrated in this embodiment, the invention is not limited thereto.

The first sub-area SA1 and the second sub-area SA2 of the display area DA are disposed at left and right sides of the main area MA and shaded to be distinguished. In an embodiment of the invention, the thin-film pattern may be simultaneously defined in the main area MA, the first sub-area SA1, and the second sub-area SA2 through one mask.

Referring to FIG. 7, three kinds of light emitting openings may be defined in the pixel defining layer PDL. The light emitting openings may include first to third light emitting openings OP-R, OP-G, and OP-B. A planar area of each of the first light emitting opening OP-G, the second light emitting opening OP-R, and the third light emitting opening OP-B is proportional to a light emitting area of the corresponding pixel (or an area of the first electrode). In this embodiment, the first light emitting opening OP-G, the second light emitting opening OP-R, and the third light emitting opening OP-B may correspond to a light emitting device of a green pixel, a light emitting device of a red pixel, and a light emitting device of a blue pixel, respectively.

First to third masks MSK1 to MSK3 in FIGS. 8A, 8C, and 8D may be used to provide a light emitting layer of the green light emitting device, a light emitting layer of the red light emitting device, and a light emitting layer of the blue light emitting device in correspondence to the first light emitting opening OP-G, the second light emitting opening OP-R, and the third light emitting opening OP-B, respectively.

FIG. 8A is an enlarged view of the first mask MSK1, and FIG. 8B is a view illustrating a state in which the working substrate WS is disposed on the first mask MSK1. However, this is merely illustrative, and the embodiment of the invention is not limited to the cross-section of the working substrate WS in FIG. 8B. Three first electrodes AE-G, AE-R, and AE-B corresponding to the first light emitting opening OP-G, the second light emitting opening OP-R, and the third light emitting opening OP-B, respectively, are additionally illustrated. In FIG. 8B, the above-described fixing member CM is additionally illustrated.

The green light emitting layers may be provided on the hole control layer HCL by the mask assembly MSA (refer to FIG. 5) including the first mask MSK1. Thereafter, the red light emitting layers may be provided by the mask assembly MSA including the second mask MSK2, and the blue light emitting layers may be provided by the mask assembly MSA including the third mask MSK3. Thereafter, the electron control layer ECL and the like in FIG. 3 are additionally provided.

A second opening OP-MG of the first mask MSK1 in FIG. 8A may have a planar area greater than that of the first light emitting opening OP-G. The first light emitting opening OP-G may be defined inside the second opening OP-MG of the first mask MSK1 in a state in which the mask assembly MSA is disposed in the chamber CB, and the first mask MSK1 is aligned with the working substrate WS. The second light emitting opening OP-R may be defined inside the second opening OP-MR of the second mask MSK2 in a state in which the second mask MSK2 is aligned with the working substrate WS. The third light emitting opening OP-B may be disposed inside the second opening OP-MB of the third mask MSK3 in a state in which the third mask MSK3 is aligned with the working substrate WS.

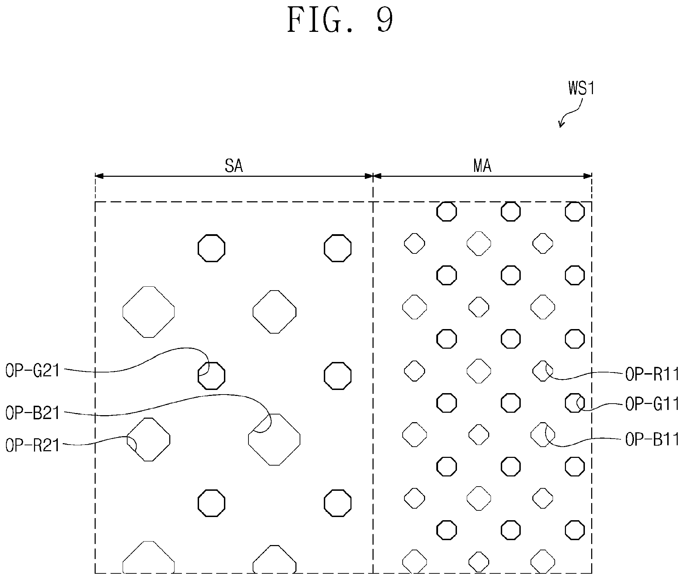

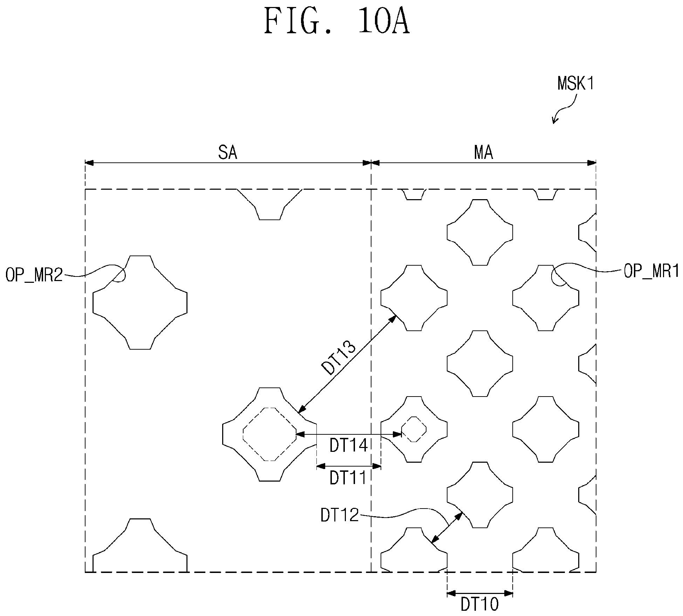

FIG. 9 is an enlarged plan view illustrating a partial area of the working substrate in FIG. 6B. FIGS. 10A to 10C are enlarged plan views illustrating an embodiment of a portion of the masks according to the invention. FIG. 9 illustrates an area including a boundary between the main area MA and the sub-area SA, and FIGS. 10A to 10C illustrate an area corresponding to the area of FIG. 9 in the first to third masks MSK1, MSK2, and MSK3. Also, openings having different shapes from FIG. 7 are illustrated in FIG. 9. However, this is merely illustrative, and the invention is not limited thereto. In an embodiment, each of the openings may have a shape corresponding to FIG. 7, for example. Hereinafter, an embodiment of the invention will be described with reference to FIGS. 9 to 10C.

The area illustrated in FIG. 9 may be an area including the boundary between the main area MA and the sub-area SA. The sub-area SA may substantially correspond to the first sub-area SA1 (refer to FIG. 6B). First to third main light emitting openings OP-R11, OP-G11, and OP-B11 of the working substrate WS1 may be defined in the main area MA and first to third sub-light emitting openings OP-R21, OP-G21, and OP-B21 of the working substrate WS1 may be defined in the sub-area SA.

Each of the first to third sub-light emitting openings OP-R21, OP-G21, and OP-B21 may have a planar area different from that of the corresponding light emitting opening of the first to third main light emitting openings OP-R11, OP-G11, and OP-B11. In an embodiment, each of the first to third sub-light emitting openings OP-R21, OP-G21, and OP-B21 may have a planar area greater than that of the corresponding light emitting opening of the first to third main light emitting openings OP-R11, OP-G11, and OP-B11, for example. The first to third sub-light emitting openings OP-R21, OP-G21, and OP-B21 may correspond to the first to third light emitting areas L-R2, L-G2, and L-B2 (refer to FIG. 2) of the sub-area SA1 in FIG. 2, respectively, and the first to third main light emitting openings OP-R11, OP-G11, and OP-B11 may correspond to the first to third light emitting areas L-R1, L-G1, and L-B1 (refer to FIG. 2) of the main area MA, respectively. Hereinafter, redundant description will be omitted.

As illustrated in FIG. 10A, in the first mask MSK1, each of openings OP_MR1 defined in the main area MA has a planar area different from that of each of openings OP_MR2 defined in the sub-area SA. Each of the openings OP_MR2 defined in the sub-area SA may have a planar area greater than that of each of the openings OP_MR1 defined in the main area MA. Also, each of the openings OP_MR1 and OP_MR2 of the first mask MSK1 may have a planar area greater than that of each of the light emitting openings OP_R11 and OP_R21 as described above. The corresponding light emitting openings OP_R11 and OP_R21 are illustrated by a dotted line for easy description.

In the first mask MSK1, the main openings OP_MR1 may be spaced apart from each other by a first horizontal gap DT10, and the openings, which are adjacent to each other in a horizontal direction, of the main openings OP_MR1 and the sub-openings OP_MR2 may be spaced apart from each other by a second horizontal gap DT11. In this embodiment, the horizontal gap may be defined as a spaced distance in the horizontal direction and may be a spaced distance in a direction perpendicular to the boundary between the main area MA and the sub-area SA. The horizontal gap in FIG. 10A may correspond to a spaced distance in the first directional axis DR1 (refer to FIG. 2). Hereinafter, redundant description will be omitted.

The main openings OP_MR1 may be spaced apart from each other by a first diagonal gap DT12, and the openings, which are adjacent to each other in a diagonal direction, of the main openings OP_MR1 and the sub-openings OP_MR2 may be spaced apart from each other by a second diagonal gap DT13. Also, the light emitting openings, which are adjacent to each other in the horizontal direction, of the main light emitting openings and the sub-light emitting openings may be spaced apart from each other by a light emitting gap DT14.

In this embodiment, the first horizontal gap DT10 may give an effect on determining the second horizontal gap DT11. Specifically, the second horizontal gap DT11 may be designed to be equal to or greater than about 0.5 times and equal to or less than about 5.0 times of the first horizontal gap DT10.

When the second horizontal gap DT11 is less than about 0.5 times of the first horizontal gap DT10, strength of the first mask MSK1 may be reduced. When the metal mask is processed by laser, higher precision may be provided, and thus the second horizontal gap DT11 may be narrowly designed. However, when the second horizontal gap DT11 is less than about 0.5 times of the first horizontal gap DT10, durability of the metal mask may be degraded. Thus, the metal mask may be easily damaged as the deposition processes are repeated, and a lifespan of the metal mask may be reduced.

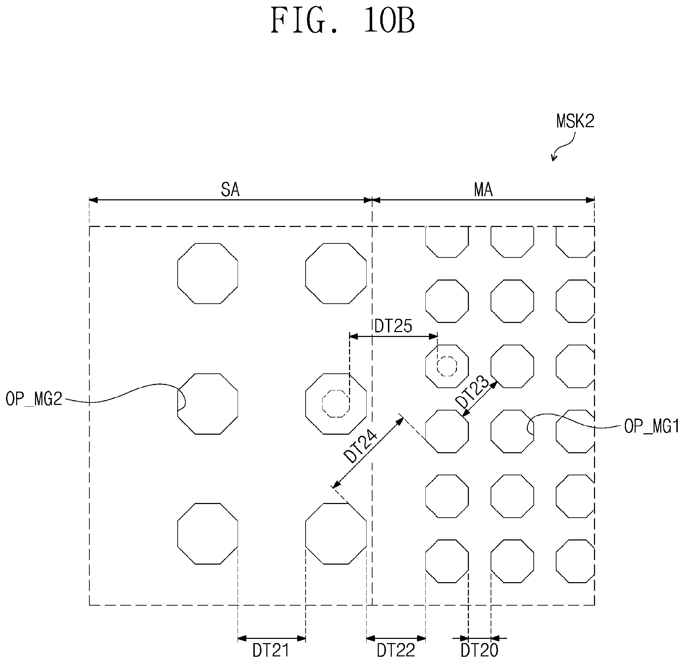

Also, when the second horizontal gap DT11 is greater than about 5 times of the first horizontal gap DT10, visibility of the boundary between the main area MA and the sub-area SA may increase. As a difference between the second horizontal gap DT11 and the first horizontal gap DT10 increases, the boundary between the main area MA and the sub-area SA may be clearly distinguished. In an embodiment of the invention, as the second horizontal gap DT11 is set to be equal to or less than about 5 times of the first horizontal gap DT10, the boundary visibility defect may be resolved, and the display panel on which an image is uniformly displayed over the entire display area may be provided. Likewise, as illustrated in FIG. 10B, in the second mask MSK2, main openings OP_MG1 are spaced apart from each other by a first horizontal gap DT20, and sub-openings OP_MG2 are spaced apart from each other by a second horizontal gap DT21. The openings, which are adjacent to each other in the horizontal direction, of the main openings OP_MG1 and the sub-openings OP_MG2 are spaced apart from each other by a third horizontal gap DT22.

The main openings OP_MG1 may be spaced apart from each other by a first diagonal gap DT23, and the openings, which are adjacent to each other in the diagonal direction, of the main openings OP_MG1 and the sub-openings OP_MG2 may be spaced apart from each other by a second diagonal gap DT24. In this embodiment, the diagonal gap may be defined as a spaced distance in the diagonal direction and may be a spaced distance in a direction diagonal to the boundary between the main area MA and the sub-area SA. The diagonal gap in FIG. 10B may correspond to a spaced space in a diagonal axis between the first directional axis DR1 and the second directional axis DR2. Hereinafter, redundant description will be omitted. Also, the light emitting openings, which are adjacent to each other in the horizontal direction, of the main light emitting openings and the sub-light emitting openings may be spaced apart from each other by a light emitting gap DT25.

In this embodiment, each of a second horizontal gap DT21 and a third horizontal gap DT22 may be designed to be equal to or greater than about 0.5 times and equal to or less than about 5.0 times of the first horizontal gap DT20. As the gap between the openings of the second mask MSK2 is designed to be equal to or greater than about 0.5 times and equal to or less than about 5.0 times of the first horizontal gap DT20, thin-film patterns capable of improving strength of the second mask MSK2 and reducing the visibility of the boundary between the main area MA and the sub-area SA may be provided.

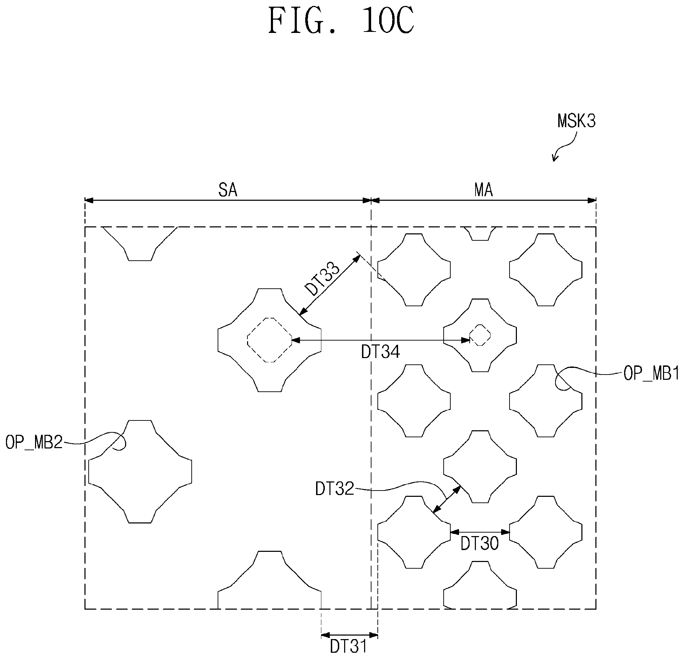

Likewise, as illustrated in FIG. 10C, in the third mask MSK3, main openings OP_MB1 may be spaced apart from each other by a first horizontal gap DT30, and the openings, which are adjacent to each other in a horizontal direction, of the main openings OP_MB1 and sub-openings OP_MB2 may be spaced apart from each other by a second horizontal gap DT31.

The main openings OP_MB1 may be spaced apart from each other by a first diagonal gap DT32, and the openings, which are adjacent to each other in the diagonal direction, of the main openings OP_MB1 and the sub-openings OP_MB2 may be spaced apart from each other by a second diagonal gap DT33. Also, the light emitting openings, which are adjacent to each other in the horizontal direction, of the main light emitting openings and the sub-light emitting openings may be spaced apart from each other by a light emitting gap DT34.

In this embodiment, the second horizontal gap DT31 may be designed to be equal to or greater than about 0.5 times and equal to or less than about 5.0 times of the first horizontal gap DT30. As the gap between the openings of the third mask MSK3 is designed to be equal to or greater than about 0.5 times and equal to or less than about 5.0 times of the first horizontal gap DT30, thin-film patterns capable of improving strength of the third mask MSK3 and reducing the visibility of the boundary between the main area MA and the sub-area SA may be provided.

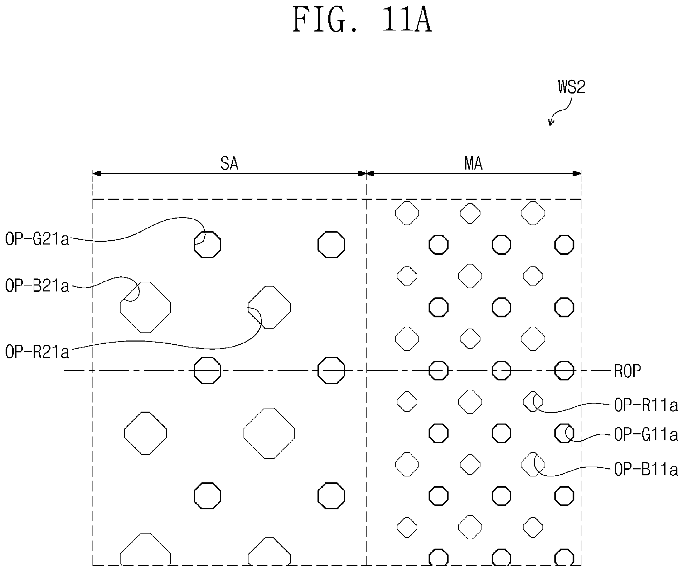

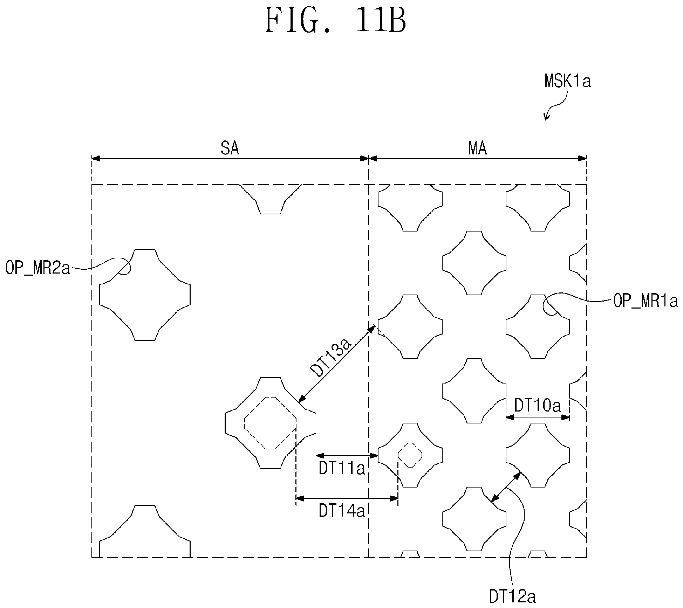

FIG. 11A is a plan view illustrating an embodiment of a portion of a working substrate in an embodiment of the invention, and FIGS. 11B to 11D are plan views illustrating portions of an embodiment of masks according to the invention. FIG. 11A illustrates an area corresponding to FIG. 9, and FIGS. 11B to 11D illustrate an area of the mask corresponding to FIG. 11A. Hereinafter, an embodiment of the invention will be described with reference to FIGS. 11A to 11D.

As illustrated in FIG. 11A, in a working substrate WS2, arrangement of light emitting openings OP-R11a, OP-G11a, OP-B11a, OP-R21a, OP-G21a, and OP-B21a may be different from that of light emitting openings OP-R11, OP-G11, OP-B11, OP-R21, OP-G21, and OP-B21 in FIG. 9. In this embodiment, the arrangement of the light emitting openings OP-R11a, OP-G11a, OP-B11a, OP-R21a, OP-G21a, and OP-B21a may be obtained by arranging the green light emitting openings OP-G11a and OP-G21a with respect to a reference axis ROP.

The green color among the primary three colors of red, green, and blue has visibility greater than that of other colors. Thus, masks MSK1a, MSK2a, and MSK3a may be designed such that a horizontal distance between the green light emitting opening OP-G11a of the main area MA and the green light emitting opening OP-G21a of the sub-area SA, which are adjacent to each other with the boundary between the main area MA and the sub-area SA therebetween, is designed to a distance preventing visibility degradation with respect to the green light emitting openings OP-G11a and OP-G21a having the mostly recognized green color. Based on this, a distance between the openings may be designed to secure durability of each of the masks MSK1a, MSK2a, and MSK3a.

As illustrated in FIG. 11B, in the first mask MSK1a, when main openings OP_MR1a are spaced apart from each other by a first diagonal distance DT12a, and openings, which are adjacent to each other at the boundary, of the main openings OP_MR1a and sub-openings OP_MR2a are spaced apart from each other by a second diagonal distance DT13a, the second diagonal distance DT13a may be designed to be equal to or greater than about 0.5 times and equal to or less than about 5.0 times of the first diagonal distance DT12a. The gaps DT10a, DT11a and DT14a of the first mask MSK1a may be similar to the gaps DT10, DT11 and DT14 of the first mask MSK1 of FIG. 10A, and detailed descriptions thereof will be omitted.

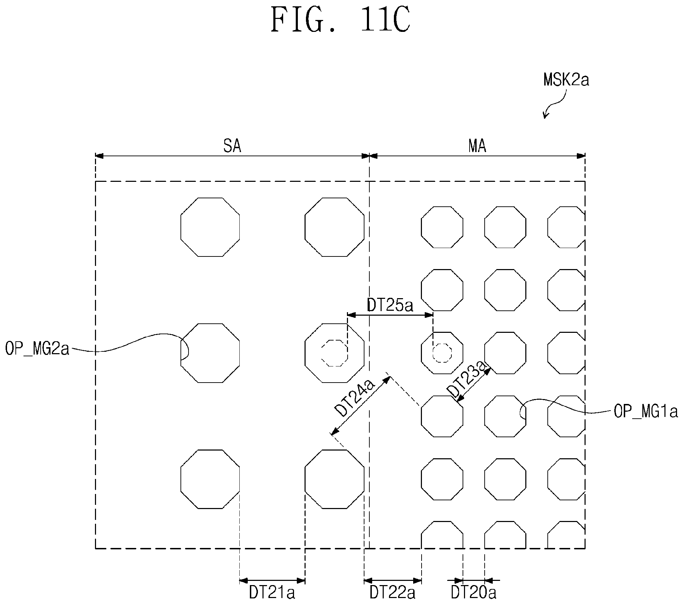

As illustrated in FIG. 11C, since the second mask MSK2a corresponds to the green light emitting openings OP-G11a and OP-G21a, in the second mask MSK2a, a portion of main openings OP-MG1a may be arranged in parallel to the horizontal direction with respect to the reference axis ROP (refer to FIG. 11A) and sub-openings OP-MG2a. A horizontal distance DT25a between the light emitting openings of the main light emitting openings and the sub-light emitting openings, which are adjacent to each other with the boundary, may be designed to be greater than the first diagonal distance DT12a of the first mask MSK1a. The gaps DT20a, DT21a, DT22a, DT23a and DT24a of the second mask MSK2a may be similar to the gaps DT20, DT21, DT22, DT23 and DT24 of the second mask MSK2 of FIG. 10B, and detailed descriptions thereof will be omitted.

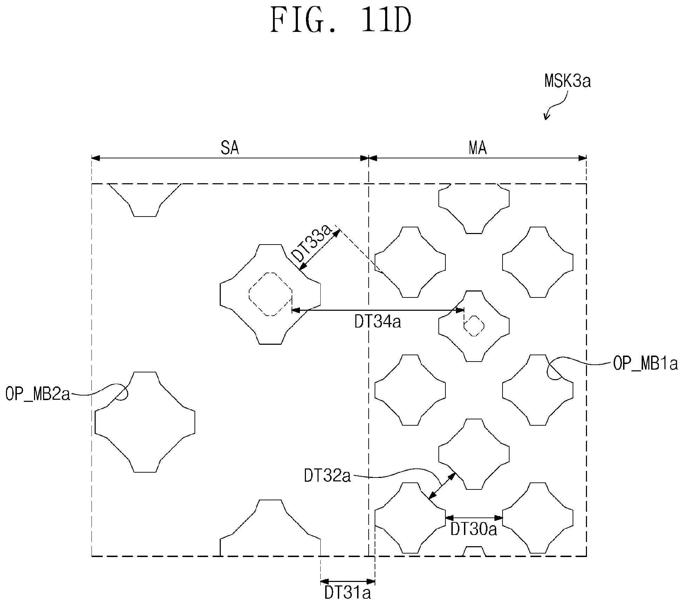

As illustrated in FIG. 11D, in the third mask MSK3a, when main openings OP_MB1a are spaced apart from each other by a first diagonal distance DT32a, and openings, which are adjacent to each other at the boundary, of the main openings OP_MB1a and sub-openings OP_MB2a are spaced apart from each other by a second diagonal distance DT33a, the second diagonal distance DT33a may be designed to be equal to or greater than about 0.5 times and equal to or less than about 5.0 times of the first diagonal distance DT32a. The gaps DT30a, DT31a and DT34a of the third mask MSK3a may be similar to the gaps DT30, DT31 and DT34 of the third mask MSK3 of FIG. 10C, and detailed descriptions thereof will be omitted.

In an embodiment of the invention, the display panel having a uniform color distribution instead of being biased to one of the red color or the blue color may be provided by designing the arrangement of the openings of the masks MSK1a, MSK2a, and MSK3a with respect to the horizontal arrangement of the light emitting pattern having the green color having high visibility. Also, the masks MSK1a, MSK2a, and MSK3a having improved durability and defining the openings having different planar areas in the main area MA and the sub-area SA may be designed.

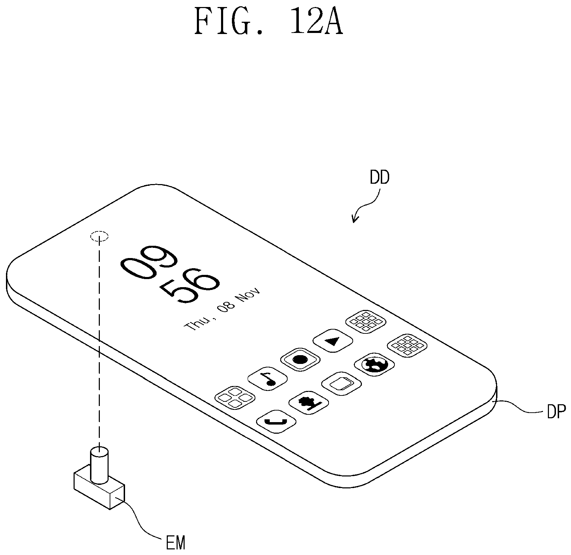

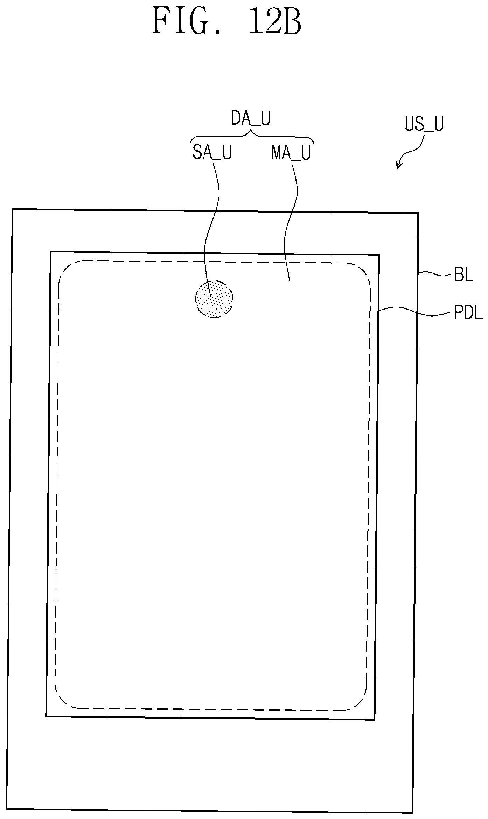

FIG. 12A is a perspective view illustrating an embodiment of a portion of a display apparatus according to the invention. FIG. 12B is a plan view of a unit cell US_U for constituting a display panel in FIG. 12A. FIG. 12B illustrates an area corresponding to FIG. 6B. Hereinafter, an embodiment of the invention will be described with reference to FIGS. 12A and 12B.

As illustrated in FIG. 12A, a display apparatus DD may include a display panel DP and an electronic module EM. The display panel DP displays an image. The electronic module EM may overlap the display panel DP in a plan view. The electronic module EM may receive light or output light to the outside through an area illustrated by a dotted line in the display panel DP. Thus, the area illustrated by a dotted line may be converted between an image displayed mode and a transparent mode.

As illustrated in FIG. 12B, a display area DA_U may include a main area MA_U and a sub-area SA_U. As described above, the sub-area SA_U may be controlled to be converted between an image displayed area or a transparent area. In this embodiment, light emitting areas disposed on the main area MA_U may have a planar area different from that of light emitting areas disposed on the sub-area.

In an embodiment of the invention, a thin-film pattern may be simultaneously provided to the main area MA_U and the sub-area SA_U having the different planar areas by one mask. Thus, the process may be simplified, and process costs may be saved. Also, as described above, as a distance between openings of the main area MA_U and the sub-area SA_U is designed to be equal to or greater than about 0.5 times and equal to or less than about 5.0 times of a distance between the openings defined in the main area MA_U, a thin-film pattern preventing visibility degradation of the main area MA_U and the sub-area SA_U may be provided, and the mask having improved durability may be provided.

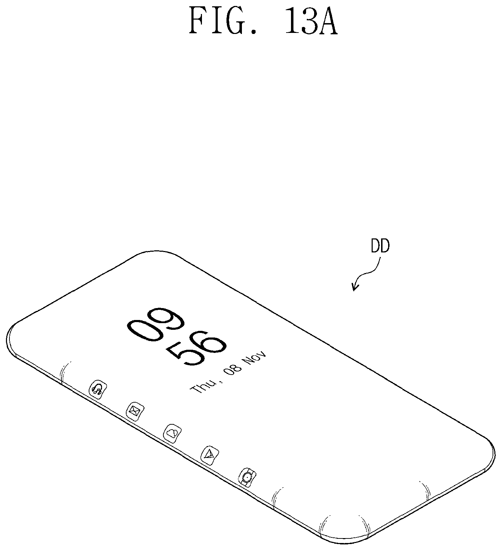

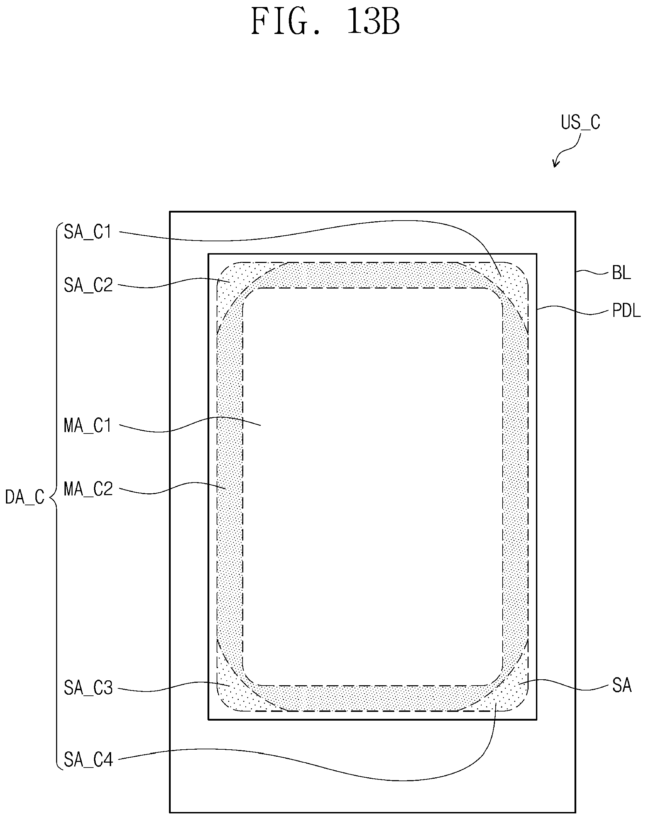

FIG. 13A is a perspective view of an embodiment of a display apparatus according to the invention. FIG. 13B is a plan view illustrating one unit cell area of the display apparatus in FIG. 13A. FIG. 13B is a view illustrating a unit cell US_C of the display apparatus in FIG. 13A and corresponding FIG. 6B. Hereinafter, an embodiment of the invention will be described with reference to FIGS. 13A to 13B.

As illustrated in FIG. 13A, a display apparatus DD may display an image on a front surface and side surfaces thereof. The display apparatus DD may have a display area DA_C having multiple areas.

As illustrated in FIG. 13B, the display area DA_C in the unit cell US_C may include a plurality of main areas MA_C1 and MA_C2 and a plurality of sub-areas SA_C1, SA_C2, SA_C3, and SA_C4. The main areas MA_C1 and MA_C2 include a first main area MA_C1 and a second main area MA_C2.

The first main area MA_C1 is disposed at a central portion of the display area DA_C. The first main area MA_C1 may correspond to a front surface of the display apparatus DD. The second main area MA_C2 may be adjacent to each of the sides of the first main area MA_C1. The second main area MA_C2 may correspond to side surfaces of the display apparatus DD.

The sub-areas SA_C1, SA_C2, SA_C3, and SA_C4 may include first to fourth sub-areas SA_C1, SA_C2, SA_C3, and SA_C4. The first to fourth sub-areas SA_C1, SA_C2, SA_C3, and SA_C4 may correspond to corners of the display apparatus DD.

In an embodiment of the invention, the main areas MA_C1 and MA_C2 and the sub-areas SA_C1, SA_C2, SA_C3, and SA_C4 may include light emitting patterns having different planar areas. Also, the first main area MA_C1 and the second main area MA_C2 may include light emitting patterns having different planar areas.

In an embodiment of the invention, the light emitting patterns disposed on the main areas MA_C1 and MA_C2 and the sub-areas SA_C1, SA_C2, SA_C3, and SA_C4 may be deposited at once by one mask defining openings having different planar areas. Thus, the process may be simplified, and process costs may be saved. Also, in an embodiment of the invention, the mask having improved durability may be provided by controlling a distance between the openings at a boundary area although the openings having different planar areas are defined.

Thus, the embodiment of the invention may provide the mask that is designed to prevent durability degradation of the metal mask including the different openings. Also, the embodiment of the invention may provide the light emitting patterns having different planar areas by one mask to simplify the process of the display apparatus and save the process costs.

Although the embodiments of the invention have been described, it is understood that the invention should not be limited to these embodiments but various changes and modifications may be made by one ordinary skilled in the art within the scope of the invention as defined by the appended claims.

## Claims

1. A metal mask (MSK, MSK1, MSK2, MSK3, MSK1a, MSK2a, MSK3a) comprising:
a first area (MA) in which a plurality of main openings (OP_MR1, OP_MG1, OP_MB1, OP_MR1a, OP_MG1a, OP_MB1a) spaced apart from each other is defined; and
a second area (SA) in which a plurality of sub-openings (OP_MR2, OP_MG2, OP_MB2, OP_MR2a, OP_MG2a, OP_MB2a) spaced apart from each other and having planar areas different from planar areas of the plurality of main openings (OP_MR1, OP_MG1, OP_MB1, OP_MR1a, OP_MG1a, OP_MB1a) is defined,
wherein a gap (DT11, DT22, DT31, DT11a, DT22a, DT31a) between a main opening of the plurality of main openings (OP_MR1, OP_MG1, OP_MB1, OP_MR1a, OP_MG1a, OP_MB1a) and a sub-opening of the plurality of sub-openings (OP_MR2, OP_MG2, OP_MB2, OP_MR2a, OP_MG2a, OP_MB2a), the main opening and the sub-opening being adjacent to each other in a first direction (DR1), wherein the gap (DT11, DT22, DT31, DT11a, DT22a, DT31a) between the main opening of the plurality of main openings (OP_MR1, OP_MG1, OP_MB1, OP_MR1a, OP_MG1a, OP_MB1a) and the sub-opening of the plurality of sub-openings (OP_MR2, OP_MG2, OP_MB2, OP_MR2a, OP_MG2a, OP_MB2a) is a spaced distance in the first direction (DR1) between the main openings (OP_MR1, OP_MG1, OP_MB1, OP_MR1a, OP_MG1a, OP_MB1a) and the sub-openings (OP_MR2, OP_MG2, OP_MB2, OP_MR2a, OP_MG2a, OP_MB2a), and wherein the first direction (DR1) is perpendicular to a boundary between the first area (MA) and the second area (SA), is equal to or greater than about 0.5 times and equal to or less than about 5.0 times of a gap (DT10, DT20, DT30, DT10a, DT20a, DT30a) between the main openings, which are adjacent to each other in the first direction (DR1), of the plurality of main openings (OP_MR1, OP_MG1, OP_MB1, OP_MR1a, OP_MG1a, OP_MB1a), wherein the gap between the main openings of the plurality of main openings is a spaced distance in the first direction (DR1) between the main openings,
wherein a number of the plurality of main openings (OP_MR1, OP_MG1, OP_MB1, OP_MR1a, OP_MG1a, OP_MB1a) per unit area in the first area (MA) is greater than a number of the plurality of sub-openings (OP_MR2, OP_MG2, OP_MB2, OP_MR2a, OP_MG2a, OP_MB2a) per unit area in the second area (SA).

2. The metal mask (MSK, MSK1, MSK2, MSK3, MSK1a, MSK2a, MSK3a) of claim 1, wherein the sub-opening has a planar area greater than a planar area of the main opening.

3. The metal mask (MSK2, MSK2a) of claim 1 or claim 2, wherein a gap (DT21, DT21a) between the sub-openings, which are adjacent to each other in the first direction (DR1), of the plurality of sub-openings (OP_MG2, OP_MG2a) is greater than the gap (DT20, DT20a) between the main openings.

4. The metal mask (MSK, MSK1, MSK2, MSK3, MSK1a, MSK2a, MSK3a) of any one of claims 1 to 3, wherein a gap (DT13, DT24, DT33, DT13a, DT24a, DT33a) between a main opening of the plurality of main openings (OP_MR1, OP_MG1, OP_MB1, OP_MR1a, OP_MG1a, OP_MB1a) and a sub-opening of the plurality of sub-openings (OP_MR2, OP_MG2, OP_MB2, OP_MR2a, OP_MG2a, OP_MB2a), the main opening and the sub-opening being adjacent to each other in a second direction tilted from the first direction (DR1), is equal to or greater than about 0.5 times and equal to or less than about 5.0 times of a gap (DT12, DT23, DT32, DT12a, DT23a, DT32a) between the main openings, which are adjacent to each other in the second direction, of the plurality of main openings (OP_MR1, OP_MG1, OP_MB1, OP_MR1a, OP_MG1a, OP_MB1a).

5. The metal mask (MSK, MSK1, MSK2, MSK3, MSK1a, MSK2a, MSK3a) of any one of claims 1 to 4, wherein:
(i) the second area (SA) is provided in plural, and
second areas (SA) are spaced apart from each other in the first direction (DR1) with the first area (MA) therebetween; or
(ii) the second area (SA) is surrounded by the first area (MA); or
(iii) the second area (SA) is provided in plural, and
second areas (SA) are adjacent to corners of the first area (MA), respectively.

6. A display apparatus comprising:
a base substrate (BL); and
a plurality of light emitting devices (OLED) disposed on the base substrate (BL) and each comprising a light emitting pattern,
wherein the plurality of light emitting devices (OLED) comprises:
a plurality of main light emitting devices (L-R1, L-B1, L-G1) disposed in a first area (MA) and each comprising a plurality of main light emitting patterns each having a first planar area (UA1); and
a plurality of sub-light emitting devices (L-R2, L-B2, L-G2) disposed in a second area (SA1, SA2) different from the first area (MA) and each comprising a sub-light emitting pattern having a second planar area (UA2) different from the first planar area (UA1),
the plurality of main light emitting devices (L-R1, L-B1, L-G1) and the plurality of sub-light emitting devices (L-R2, L-B2, L-G2) emit light having the same color as each other, and
a gap between the main light emitting pattern and the sub-light emitting pattern, which are adjacent to each other along a first direction (DR1), wherein the gap between the main light emitting pattern and the sub-light emitting pattern is a spaced distance in the first direction (DR1) between the main light emitting patterns and the sub-light emitting patterns, and wherein the first direction (DR1) is perpendicular to a boundary between the first area (MA) and the second area (SA), is equal to or greater than about 0.5 times and equal to or less than about 5.0 times of a gap between the main light emitting patterns, which are adjacent to each other along the first direction (DR1), of the plurality of main light emitting patterns, wherein the gap between the main light emitting patterns is a spaced distance in the first direction (DR1) between the main light emitting patterns,
wherein a number of the main light emitting patterns per unit area in the first area (MA) is greater than a number of the sub-light emitting patterns per unit area in the second area (SA1, SA2).

7. The display apparatus of claim 6, further comprising a driving circuit disposed on the second area (SA1, SA2),
wherein at least a portion of the plurality of sub-light emitting devices (L-R2, L-B2, L-G2) overlap the driving circuit (SDC1, SDC2) in a plan view.

8. The display apparatus of claim 6, further comprising an electronic module (EM) disposed in overlap with the second area (SA1, SA2),
wherein the second area (SA1, SA2) has a transmittance less than a transmittance of the first area (MA).

9. The display apparatus of any one of claims 6 to 8, wherein the second planar area (UA2) is greater than the first planar area (UA1).

10. The display apparatus of any one of claims 6 to 9, wherein the main light emitting pattern and the sub-light emitting pattern, which are adjacent to each other, are arranged along a reference axis extending in the first direction (DR1), optionally wherein the plurality of light emitting devices (OLED) emits light having a green color.

11. The display apparatus of any one of claims 6 to 10, wherein a gap between the main light emitting pattern and the sub-light emitting pattern, which are adjacent to each other in a second direction tilted from the first direction (DR1), is equal to or greater than about 0.5 times and equal to or less than about 5.0 times of a gap between main light emitting patterns, which are adjacent to each other in the second direction, of the plurality of the main light emitting patterns, optionally wherein the plurality of light emitting devices (OLED) emits red or blue light.

12. The display apparatus of any one of claims 6 to 11, wherein the second area (SA1, SA2) is provided in plural, and
second areas (SA1, SA2) are adjacent to corners of the first area (MA), respectively.

13. The display apparatus of any one of claims 6 to 12, further comprising additional main light emitting patterns disposed on the first area (MA) to emit light having a color different from a color of the main light emitting patterns,
wherein at least a portion of the additional main light emitting patterns and the main light emitting patterns overlap each other in a plan view.

14. The display apparatus of claim 13, further comprising additional sub-light emitting patterns disposed on the second area (SA1, SA2) to emit light having a same color as a color of the additional main light emitting patterns,
wherein the additional sub-light emitting patterns and the sub-light emitting patterns are spaced apart from each other in a plan view.

## Patentansprüche

1. Metallmaske (MSK, MSK1, MSK2, MSK3, MSK1a, MSK2a, MSK3a), umfassend:
eine erste Fläche (MA), in der eine Vielzahl von Hauptöffnungen (OP_MR1, OP_MG1, OP_MB1, OP_MR1a, OP_MG1a, OP_MB1a) definiert ist, die voneinander beabstandet sind; und
eine zweite Fläche (SA), in der eine Vielzahl von Nebenöffnungen (OP_MR2, OP_MG2, OP_MB2, OP_MR2a, OP_MG2a, OP_MB2a) definiert ist, die voneinander beabstandet sind und ebene Flächen aufweisen, die sich von den ebenen Flächen der Vielzahl von Hauptöffnungen (OP_MR1, OP_MG1, OP_MB1, OP_MR1a, OP_MG1a, OP_MB1a) unterscheiden,
wobei ein Spalt (DT11, DT22, DT31, DT11a, DT22a, DT31a) zwischen einer Hauptöffnung der Vielzahl von Hauptöffnungen (OP_MR1, OP_MG1, OP_MB1, OP_MR1a, OP_MG1a, OP_MB1a) und einer Nebenöffnung der Vielzahl von Nebenöffnungen (OP_MR2, OP_MG2, OP_MB2, OP_MR2a, OP_MG2a, OP_MB2a), wobei die Hauptöffnung und die Nebenöffnung in einer ersten Richtung (DR1) benachbart sind, wobei der Spalt (DT11, DT22, DT31, DT11a, DT22a, DT31a) zwischen der Hauptöffnung der Vielzahl von Hauptöffnungen (OP_MR1, OP_MG1, OP_MB1, OP_MR1a, OP_MG1a, OP_MB1a) und der Nebenöffnung der Vielzahl von Nebenöffnungen (OP_MR2, OP_MG2, OP_MB2, OP_MR2a, OP_MG2a, OP_MB2a) ein beabstandeter Abstand in der ersten Richtung (DR1) zwischen den Hauptöffnungen (OP_MR1, OP_MG1, OP_MB1, OP_MR1 A, OP_MG1a, OP_MB1a) und den Nebenöffnungen (OP_MR2, OP_MG2, OP_MB2, OP_MR2a, OP_MG2a, OP_MB2a) ist, und wobei die erste Richtung (DR1) senkrecht zu einer Grenze zwischen der ersten Fläche (MA) und der zweiten Fläche (SA) ist, gleich oder größer als etwa 0,5-mal und gleich oder kleiner als etwa 5,0-mal ein Spalt (DT10, DT20, DT30, DT10a, DT20a, DT30a) zwischen den Hauptöffnungen der Vielzahl von Hauptöffnungen (OP_MR1, OP_MG1, OP_MB1, OP_MR1a, OP_MG1a, OP_MB1a) ist, die einander in der ersten Richtung (DR1) benachbart sind, wobei der Spalt zwischen den Hauptöffnungen der Vielzahl von Hauptöffnungen in der ersten Richtung (DR1) zwischen den Hauptöffnungen ein beabstandeter Abstand ist,
wobei eine Anzahl der Vielzahl von Hauptöffnungen (OP_MR1, OP_MG1, OP_MB1, OP_MR1a, OP_MG1a, OP_MB1a) pro Flächeneinheit in der ersten Fläche (MA) größer ist als eine Anzahl der Vielzahl von Nebenöffnungen. (OP_MR2, OP_MG2, OP_MB2, OP_MR2a, OP_MG2a, OP_MB2a) pro Flächeneinheit in der zweiten Fläche (SA).

2. Metallmaske (MSK, MSK1, MSK2, MSK3, MSK1a, MSK2a, MSK3a) nach Anspruch 1, wobei die Nebenöffnung eine ebene Fläche aufweist, die größer als eine ebene Fläche der Hauptöffnung ist.

3. Metallmaske (MSK2, MSK2a) nach Anspruch 1 oder Anspruch 2, wobei ein Spalt (DT21, DT21a) zwischen den Nebenöffnungen der Vielzahl von Nebenöffnungen (OP_MG2, OP_MG2a), die einander in der ersten Richtung (DR1) benachbart sind, größer als der Spalt (DT20, DT20a) zwischen den Hauptöffnungen ist.

4. Metallmaske (MSK, MSK1, MSK2, MSK3, MSK1a, MSK2a, MSK3a) nach einem der Ansprüche 1 bis 3, wobei ein Spalt (DT13, DT24, DT33, DT13a, DT24a, DT33a) zwischen einer Hauptöffnung der Vielzahl von Hauptöffnungen (OP_MR1, OP_MG1, OP_MB1, OP_MR1a, OP_MG1a, OP_MB1a) und einer Nebenöffnung der Vielzahl von Nebenöffnungen (OP_MR2, OP_MG2, OP_MB2, OP_MR2a, OP_MG2a, OP_MB2a), wobei die Hauptöffnung und die Nebenöffnung einander in einer zweiten Richtung benachbart sind, die von der ersten Richtung (DR1) geneigt ist, gleich oder größer als etwa 0,5-mal und gleich oder kleiner als etwa 5,0-mal ein Spalt (DT12, DT23, DT32, DT12a, DT23a, DT32a) zwischen den Hauptöffnungen der Vielzahl von Hauptöffnungen. (OP_MR1, OP_MG1, OP_MB1, OP_MR1a, OP_MG1a, OP_MB1a) ist, die einander in der zweiten Richtung benachbart sind.

5. Metallmaske (MSK, MSK1, MSK2, MSK3, MSK1a, MSK2a, MSK3a) nach einem der Ansprüche 1 bis 4, wobei:
(i) die zweite Fläche (SA) mehrfach bereitgestellt ist, und
zweite Flächen (SA) in der ersten Richtung (DR1) voneinander beabstandet sind, mit der ersten Fläche (MA) dazwischen; oder
(ii) die zweite Fläche (SA) von der ersten Fläche (MA) umgeben ist; oder
(iii) die zweite Fläche (SA) mehrfach bereitgestellt ist, und
zweite Flächen (SA) jeweils Ecken der ersten Fläche (MA) benachbart sind.

6. Anzeigeeinrichtung, umfassend:
ein Basissubstrat (BL); und
eine Vielzahl von Leuchtvorrichtungen (OLED), die auf dem Basissubstrat (BL) angeordnet sind und jeweils ein Leuchtmuster umfassen,
wobei die Vielzahl von Leuchtvorrichtungen (OLED) Folgendes umfasst:
eine Vielzahl von Hauptleuchtvorrichtungen (L-R1, L-B1, L-G1), die in einer ersten Fläche (MA) angeordnet sind und jeweils eine Vielzahl von Hauptleuchtmustern umfassen, die jeweils eine erste ebene Fläche (UA1) aufweisen; und
eine Vielzahl von Nebenleuchtvorrichtungen (L-R2, L-B2, L-G2), die in einer zweiten Fläche (SA1, SA2) angeordnet sind, die sich von der ersten Fläche (MA) unterscheidet, und jeweils ein Nebenleuchtmuster umfassen, das eine zweiten ebene Fläche (UA2) aufweist, die sich von der ersten ebenen Fläche (UA1) unterscheidet,
wobei die Vielzahl von Hauptleuchtvorrichtungen (L-R1, L-B1, L-G1) und die Vielzahl von Nebenleuchtvorrichtungen (L-R2, L-B2, L-G2) Licht emittieren, das die gleiche Farbe aufweist wie jede andere, und
ein Spalt zwischen dem Hauptleuchtmuster und dem Nebenleuchtmuster, die einander entlang einer ersten Richtung (DR1) benachbart sind, wobei der Spalt zwischen dem Hauptleuchtmuster und dem Nebenleuchtmuster ein beabstandeter Abstand in der ersten Richtung (DR1) zwischen den Hauptleuchtmustern und den Nebenleuchtmustern ist und wobei die erste Richtung (DR1) senkrecht zu einer Grenze zwischen der ersten Fläche (MA) und der zweiten Fläche (SA) ist, gleich oder größer als etwa 0,5-mal und gleich oder kleiner als etwa 5,0-mal ein Spalt zwischen den Hauptleuchtmustern der Vielzahl von Hauptleuchtmustern ist, die einander entlang der ersten Richtung (DR1) benachbart sind, wobei der Spalt zwischen den Hauptleuchtmustern ein beabstandeter Abstand in der ersten Richtung (DR1) zwischen den Hauptleuchtmustern ist,
wobei eine Anzahl der Hauptleuchtmuster pro Flächeneinheit in der ersten Fläche (MA) größer als eine Anzahl der Nebenleuchtmuster pro Flächeneinheit in der zweiten Fläche (SA1, SA2) ist.

7. Anzeigeeinrichtung nach Anspruch 6, weiter umfassend eine Ansteuerschaltung, die in der zweiten Fläche (SA1, SA2) angeordnet ist,
wobei mindestens ein Anteil der Vielzahl von Nebenleuchtvorrichtungen (L-R2, L-B2, L-G2) die Ansteuerschaltung (SDC1, SDC2) in einer Draufsicht überlappt.

8. Anzeigeeinrichtung nach Anspruch 6, weiter umfassend ein elektronisches Modul (EM), das mit der zweiten Fläche (SA1, SA2) in Überlappung angeordnet ist,
wobei die zweite Fläche (SA1, SA2) eine Lichtdurchlässigkeit aufweist, die kleiner ist als die Lichtdurchlässigkeit der ersten Fläche (MA).

9. Anzeigeeinrichtung nach einem der Ansprüche 6 bis 8, wobei die zweite ebene Fläche (UA2) größer als die erste ebene Fläche (UA1) ist.

10. Anzeigeeinrichtung nach einem der Ansprüche 6 bis 9, wobei das Hauptleuchtmuster und das Nebenleuchtmuster, die einander benachbart sind, entlang einer sich in der ersten Richtung erstreckenden Bezugsachse (DR1) eingerichtet sind, wobei die Vielzahl von Leuchtvorrichtungen (OLED) gegebenenfalls Licht emittiert, das eine grüne Farbe aufweist.

11. Anzeigeeinrichtung nach einem der Ansprüche 6 bis 10, wobei ein Spalt zwischen dem Hauptleuchtmuster und dem Nebenleuchtmuster der Vielzahl von Hauptleuchtmustern, die einander in einer zweiten Richtung benachbart sind, die von der ersten Richtung (DR1) geneigt ist, gleich oder größer als etwa 0,5-mal und gleich oder kleiner als etwa 5,0-mal ein Spalt zwischen den Hauptleuchtmustern ist, die einander in der zweiten Richtung benachbart sind, wobei die Vielzahl der Hauptleuchtvorrichtungen (OLED) gegebenenfalls rotes oder blaues Licht emittiert.

12. Anzeigeeinrichtung nach einem der Ansprüche 6 bis 11, wobei die zweite Fläche (SA1, SA2) mehrfach bereitgestellt ist und
zweite Flächen (SA1, SA2) jeweils Ecken der ersten Fläche (MA) benachbart sind.

13. Anzeigeeinrichtung nach einem der Ansprüche 6 bis 12, weiter umfassend zusätzliche Hauptleuchtmuster, die auf der ersten Fläche (MA) angeordnet sind, um Licht zu emittieren, das eine Farbe aufweist, die sich von der Farbe der Hauptleuchtmuster unterscheidet,
wobei sich mindestens ein Anteil der zusätzlichen Hauptleuchtmuster und der Hauptleuchtmuster in einer Draufsicht einander überlappen.

14. Anzeigeeinrichtung nach Anspruch 13, weiter umfassend zusätzliche Nebenleuchtmuster, die auf der zweiten Fläche (SA1, SA2) angeordnet sind, um Licht zu emittieren, das eine gleiche Farbe aufweist wie eine Farbe der zusätzlichen Hauptleuchtmuster,
wobei die zusätzlichen Nebenleuchtmuster und die Nebenleuchtmuster in einer Draufsicht voneinander beabstandet sind.

## Revendications

1. Masque métallique (MSK, MSK1, MSK2, MSK3, MSK1a, MSK2a, MSK3a) comprenant :
une première zone (MA) dans laquelle une pluralité d'ouvertures principales (OP_MR1, OP_MG1, OP_MB1, OP_MR1a, OP_MG1a, OP_MB1a) espacées les unes des autres est définie ; et
une seconde zone (SA) dans laquelle une pluralité de sous-ouvertures (OP_MR2, OP_MG2, OP_MB2, OP_MR2a, OP_MG2a, OP_MB2a) espacées les unes des autres et présentant des surfaces planes différentes de celles des multiples ouvertures principales (OP_MR1, OP_MG1, OP_MB1, OP_MR1a, OP_MG1a, OP_MB1a) est définie,
dans lequel un espace (DT11, DT22, DT31, DT11a, DT22a, DT31a) entre une ouverture principale de la pluralité d'ouvertures principales (OP_MR1, OP_MG1, OP_MB1, OP_MR1a, OP_MG1a, OP_MB1a) et une sous-ouverture de la pluralité de sous-ouvertures (OP_MR2, OP_MG2, OP_MB2, OP_MR2a, OP_MG2a, OP_MB2a), l'ouverture principale et la sous-ouverture étant adjacentes l'une à l'autre dans une première direction (DR1), dans lequel l'espace (DT11, DT22, DT31, DT11a, DT22a, DT31a) entre l'ouverture principale de la pluralité d'ouvertures principales (OP_MR1, OP_MG1, OP_MB1, OP_MR1a, OP_MG1a, OP_MB1a) et la sous-ouverture de la pluralité de sous-ouvertures (OP_MR2, OP_MG2, OP_MB2, OP_MR2a, OP_MG2a, OP_MB2a) est une distance espacée dans la première direction (DR1) entre les ouvertures principales (OP_MR1, OP_MG1, OP_MB1, OP_MR1 a, OP_MG1a, OP_MB1a) et les sous-ouvertures (OP_MR2, OP_MG2, OP_MB2, OP_MR2a, OP_MG2a, OP_MB2a), et dans laquelle la première direction (DR1) est perpendiculaire à une limite entre la première zone (MA) et la seconde zone (SA), est égale ou supérieure à environ 0,5 fois et égale ou inférieure à environ 5,0 fois un espace (DT10, DT20, DT30, DT10a, DT20a, DT30a) entre les ouvertures principales, qui sont adjacentes les unes aux autres dans la première direction (DR1), de la pluralité d'ouvertures principales (OP_MR1, OP_MG1, OP_MB1, OP_MR1a, OP_MG1a, OP_MB1a), dans lequel l'espace entre les ouvertures principales de la pluralité d'ouvertures principales est une distance espacée dans la première direction (DR1) entre les ouvertures principales,
dans lequel un certain nombre des ouvertures principales (OP_MR1, OP_MG1, OP_MB1, OP_MR1a, OP_MG1a, OP_MB1a) par unité de surface dans la première zone (MA) est supérieure à un certain nombre de la pluralité de sous-ouvertures (OP_MR2, OP_MG2, OP_MB2, OP_MR2a, OP_MG2a, OP_MB2a) par unité de surface dans la seconde zone (SA).

2. Masque métallique (MSK, MSK1, MSK2, MSK3, MSK1a, MSK2a, MSK3a) selon la revendication 1, dans lequel la sous-ouverture présente une surface plane supérieure à la surface plane de l'ouverture principale.

3. Masque métallique (MSK2, MSK2a) selon la revendication 1 ou de la revendication 2, dans lequel un espace (DT21, DT21a) entre les sous-ouvertures, qui sont adjacentes les unes aux autres dans la première direction (DR1), de la pluralité de sous-ouvertures (OP_MG2, OP_MG2a) est supérieur à l'espace (DT20, DT20a) entre les ouvertures principales.

4. Masque métallique (MSK, MSK1, MSK2, MSK3, MSK1a, MSK2a, MSK3a) selon l'une quelconque des revendications 1 à 3, dans lequel un espace (DT13, DT24, DT33, DT13a, DT24a, DT33a) entre une ouverture principale de la pluralité d'ouvertures principales (OP_MR1, OP_MG1, OP_MB1, OP_MR1a, OP_MG1a, OP_MB1a) et une sous-ouverture de la pluralité de sous-ouvertures (OP_MR2, OP_MG2, OP_MB2, OP_MR2a, OP_MG2a, OP_MB2a), l'ouverture principale et la sous-ouverture étant adjacentes l'une à l'autre dans une seconde direction inclinée par rapport à la première direction (DR1), est égale ou supérieure à environ 0,5 fois et égale ou inférieure à environ 5,0 fois un espace (DT12, DT23, DT32, DT12a, DT23a, DT32a) entre les ouvertures principales, qui sont adjacentes l'une à l'autre dans la seconde direction, de la pluralité d'ouvertures principales (OP_MR1, OP_MG1, OP_MB1, OP_MR1a, OP_MG1a, OP_MB1a).

5. Masque métallique (MSK, MSK1, MSK2, MSK3, MSK1a, MSK2a, MSK3a) selon l'une quelconque des revendications 1 à 4, dans lequel :
(i) la seconde zone (SA) est fournie en plusieurs exemplaires, et
des secondes zones (SA) sont espacées les unes des autres dans la première direction (DR1), la première zone (MA) se trouvant entre elles ; ou
(ii) la seconde zone (SA) est entourée par la première zone (MA) ; ou
(iii) la seconde zone (SA) est fournie en plusieurs exemplaires, et
des secondes zones (SA) sont respectivement adjacentes aux coins de la première zone (MA).

6. Appareil d'affichage comprenant :
un substrat de base (BL) ;
une pluralité de dispositifs électroluminescents (OLED) disposés sur le substrat de base (BL) et comprenant chacun un motif d'émission de lumière,
dans lequel la pluralité de dispositifs électroluminescents (OLED) comprend :
une pluralité de dispositifs d'émission de lumière principale (L-R1, L-B1, L-G1) disposés dans une première zone (MA) et comprenant chacun une pluralité de motifs d'émission de lumière principale, chacun présentant une première zone plane (UA1) ; et
une pluralité de dispositifs d'émission de sous-lumière (L-R2, L-B2, L-G2) disposés dans une seconde zone (SA1, SA2) différente de la première zone (MA) et comprenant chacun un motif d'émission de sous-lumière présentant une seconde zone plane (UA2) différente de la première zone plane (UA1),
la pluralité des dispositifs d'émission de lumière principale (L-R1, L-B1, L-G1) et la pluralité des dispositifs d'émission de sous-lumière (L-R2, L-B2, L-G2) émettent une lumière présentant la même couleur, et
un espace entre le motif d'émission de lumière principale et le motif d'émission de sous-lumière, adjacents l'un à l'autre selon une première direction (DR1), dans lequel l'espace entre le motif d'émission de lumière principale et le motif d'émission de sous-lumière correspond à une distance dans la première direction (DR1) entre les motifs d'émission de lumière principale et les motifs d'émission de sous-lumière, et dans lequel la première direction (DR1) est perpendiculaire à une limite entre la première zone (MA) et la seconde zone (SA), est supérieur ou égal à environ 0,5 fois et inférieur ou égal à environ 5,0 fois un espace entre les motifs d'émission de lumière principale adjacents l'un à l'autre selon la première direction (DR1), parmi la pluralité de motifs d'émission de lumière principale, dans lequel l'espace correspond à la distance d'espace dans la première direction (DR1) entre les motifs d'émission de lumière principale,
dans lequel le nombre de motifs d'émission de lumière principale par unité de surface dans la première zone (MA) est supérieur au nombre de motifs d'émission de sous-lumière par unité de surface dans la seconde zone (SA1, SA2).

7. Appareil d'affichage selon la revendication 6, comprenant en outre un circuit de commande disposé sur la seconde zone (SA1, SA2),
dans lequel au moins une partie de la pluralité de dispositifs d'émission de sous-lumière (L-R2, L-B2, L-G2) chevauche le circuit de commande (SDC1, SDC2) dans une vue en plan.

8. Appareil d'affichage selon la revendication 6, comprenant en outre un module électronique (EM) disposé en chevauchement avec la seconde zone (SA1, SA2),
dans laquelle la seconde zone (SA1, SA2) présente une transmittance inférieure à celle de la première zone (MA).

9. Appareil d'affichage selon l'une quelconque des revendications 6 à 8, dans lequel la deuxième surface plane (UA2) est plus grande que la première surface plane (UA1).

10. Appareil d'affichage selon l'une quelconque des revendications 6 à 9, dans lequel le motif d'émission de lumière principale et le motif d'émission de sous-lumière, qui sont adjacents l'un à l'autre, sont agencés le long d'un axe de référence s'étendant dans la première direction (DR1), dans lequel la pluralité de dispositifs d'émission de lumière (OLED) émet une lumière de couleur verte.

11. Appareil d'affichage selon l'une quelconque des revendications 6 à 10, dans lequel un espace entre le motif d'émission de lumière principale et le motif d'émission de sous-lumière, qui sont adjacents l'un à l'autre dans une deuxième direction inclinée par rapport à la première direction (DR1), est égal ou supérieur à environ 0,5 fois et égal ou inférieur à environ 5,0 fois un espace entre les motifs d'émission de lumière principale, qui sont adjacents l'un à l'autre dans la deuxième direction, de la pluralité des motifs d'émission de lumière principale, en option dans lequel la pluralité de dispositifs d'émission de lumière (OLED) émet de la lumière rouge ou bleue.

12. Appareil d'affichage selon l'une quelconque des revendications 6 à 11, dans lequel la seconde zone (SA1, SA2) est représentée en plusieurs exemplaires, et
des secondes zones (SA1, SA2) sont respectivement adjacentes aux coins de la première zone (MA).

13. Appareil d'affichage selon l'une quelconque des revendications 6 à 12, comprenant en outre des motifs d'émission de lumière principale supplémentaires disposés sur la première zone (MA) pour émettre une lumière présentant une couleur différente de celle des motifs d'émission de lumière principale,
dans lequel au moins une partie des motifs d'émission de lumière principale supplémentaires et des motifs d'émission de lumière principale se chevauchent en vue en plan.

14. Appareil d'affichage selon la revendication 13, comprenant en outre des motifs d'émission de sous-lumière supplémentaires disposés sur la seconde zone (SA1, SA2) pour émettre une lumière présentant la même couleur qu'une couleur des motifs d'émission de lumière principale supplémentaires,
dans lequel les motifs d'émission de sous-lumière supplémentaires et les motifs d'émission de sous-lumière sont espacés l'un de l'autre en vue en plan.
